(19) Europäisches Patentamt European Patent Office Office européen des brevets

(11) **EP 4 556 928 A1**

(12) **EUROPEAN PATENT APPLICATION**

(43) Date of publication:
**21.05.2025 Bulletin 2025/21**

(21) Application number: **23209949.9**

(22) Date of filing: **15.11.2023**

(51) International Patent Classification (IPC):
**G01R 31/62** $^{(2020.01)}$ **G01R 31/72** $^{(2020.01)}$

(52) Cooperative Patent Classification (CPC):
**G01R 31/62; G01R 31/72;** G01R 31/50

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Hitachi Energy Ltd**
**8050 Zürich (CH)**

(72) Inventors:
• **Chakravorty, Jhelum**
**H3G1Y2 Montreal, Québec (CA)**

• **Ripamonti, Nicolo**
**5400 Baden (CH)**
• **Yada, Susumu**
**11761 Stockholm (SE)**
• **Luvisotto, Michele**
**723 34, Västerås (SE)**
• **Mukherjee, Pritam**
**72227 Västerås (SE)**

(74) Representative: **Meier, Florian**
**meier ip**
**Buschingstraße 65 (6. OG)**
**81677 München (DE)**

(54) **METHOD AND PROCESSING SYSTEM FOR USE WITH AN ASSET OF AN ELECTRIC POWER SYSTEM**

(57) To process measurements acquired using measurement instrumentation (41, 42), a processing system (50) is operative to perform a data-driven processing technique to determine at least one parameter related to an asset (20) of an electric power system (10) and at least one uncertainty measure.

FIG. 1

**EP 4 556 928 A1**

**Description**

TECHNICAL FIELD

Embodiments of the invention relate to processing systems and methods for controlling and/or monitoring an electric power system. Embodiments of the invention relate in particular to processing systems and methods operative to process measurements obtained at or in proximity to an asset of the electric power system and to trigger actions responsive to the processing.

BACKGROUND

Modern electric power systems comprise several complex assets, such as transformers or shunt reactors. Failure or malfunction of such assets can have potentially catastrophic consequences. Monitoring of such assets can represent a considerable challenge. For illustration, some assets may have a tank comprising a tank wall. Local losses in such assets can be difficult to monitor, in part due to structural components of the tank wall. As a consequence, there is a risk that potential issues related to, e.g., local losses in such complex assets may remain unnoticed for undesirably long time periods.

US 2020/0293594 A1 discloses a technique in which an object is modeled with a differential equation. F. Bragone et al., "Physics-informed neural networks for modelling power transformer's dynamic thermal behaviour", Electric Power Systems Research Volume 211, October 2022, 108447, Elsevier (2022) discloses thermal modelling of power transformers using physics-informed neural networks (PINNs). C. Moya et al., "DeepONet-Grid-UQ: A Trustworthy Deep Operator Framework for Predicting the Power Grid's Post-Fault Trajectories", arXiv:2202.07176 discloses a data-driven method for the prediction of power system post-fault trajectories.

Processing techniques as discussed in the before-mentioned documents provide data-driven techniques suitable for assets. Such techniques are beneficial in that they mitigate the risk of human-induced error. However, there is still a need for enhanced techniques that allow local losses, malfunctions, or other potentially relevant operating situations to be detected. For illustration, it would be desirable to provide techniques capable of using measurements obtained from, e.g., an instrumentation location externally of an asset tank wall to infer conditions at locations for which measurements are not readily available due to, e.g., structural components of the tank wall. It would also be desirable to provide techniques that allow reliability of inferred parameters to be taken into consideration.

SUMMARY

It is an object of the invention to provide methods and/or processing systems that provide enhanced techniques of processing measurements obtained for an asset of an electric power system. There is in particular a need for such methods and/or processing systems that can determine one or several parameters associated with the asset and that are also operative to determine the reliability of the inferred one or several parameters and use the determined reliability.

According to exemplary embodiments, methods and a processing system as recited in the independent claims are provided. The dependent claims define preferred or advantageous embodiments.

According to exemplary embodiments, there are provided methods and processing systems operative to process measurements obtained on or in proximity to an asset of an electric power system using a data-driven processing technique. The data-driven processing technique may be operative to determine one or several parameters of the asset and at least one uncertainty measure for the determined one or several parameters, with the physics informed data-driven processing technique having embedded therein knowledge of a differential equation, such as a partial differential equation (PDE), e.g. a linear PDE. Output is generated based on the determined one or several parameter(s) and the at least one uncertainty measure.

Thereby, the methods do not only determine a parameter or several parameters related to the asset (such as temperature and heat) but also provide information on an uncertainty measure for at least one of these parameters. The at least one uncertainty measure can be used in various ways to generate the output, e.g., by using the uncertainty measure(s) to provide explainability, by facilitating application of the method to sparse data sets in which measurement locations on a tank wall are sparse, by using the uncertainty measure(s) to determine which spatial regions on an asset tank wall are suitable for extrapolating or interpolating the at least one parameter therefrom, without being limited thereto.

The data-driven processing technique may comprise a physics informed data-driven processing technique operative to determine one or several parameters of the asset and at least one uncertainty measure for the determined one or several parameters, with the physics informed data-driven processing technique having embedded therein knowledge of a differential equation, such as a partial differential equation (PDE), e.g. a linear PDE. The physics informed data-driven processing technique may be operative to determine a first parameter and a second parameter as a function of both spatial location on the asset and time. The first parameter and the second parameter may be related to each other by a PDE, in particular by a linear PDE. The PDE may be dependent on a time derivative of the second parameter and both a first order partial time derivative of the first parameter and a second order partial spatial derivative of the first parameter (e.g., a Laplace operator applied to the first parameter). The PDE may be a diffusion equation, e.g., a thermal diffusion equation.

Thereby, the data-driven processing technique embeds the physical relationship between several parameters that are linked to each other by the physical relationship. An example is heat and temperature that are linked to each other by a thermal diffusion equation. By determining these first and second parameters as a function of time and location and using the PDE linking the first and second parameters to each other, more robust predictions can be obtained. The reliability of the processing is enhanced.

The data-driven processing technique may be operative to use temperature measurements obtained for a plurality of measurement locations on a tank wall of the asset (e.g., of a transformer tank wall or a shunt reactor tank wall) to determine temperatures for regions at which no reliable temperature measurements are available, e.g., due to structural components of the tank wall such as reinforcements. The uncertainty measure(s) may be used to determine which spatial regions on an asset tank wall are suitable for extrapolating or interpolating the at least one parameter therefrom, for example.

Thereby, additional information not obtainable using conventional techniques is available for use in generating an output, such as an alert, warning, or other data (such as a control command) that acts on the electric power system.

A method for use in association with an asset of an electric power system according to an embodiment comprises receiving, at at least one interface of a processing system, data comprising measurements for several different measurement locations at or in proximity to the asset. The method comprises performing, by at least one processing circuit of the processing system, a determination of at least one parameter of the asset, comprising applying a data-driven processing technique to input data that are based on the measurements to determine the at least one parameter and at least one uncertainty measure for one or several parameters of the at least one parameter. The method comprises generating, by the processing system, output based on the determination.

Thereby, additional information comprising the at least one uncertainty measure is determined for use in generating an output, such as an alert, warning, or other data (such as a control command) that acts on the electric power system. Reliability is enhanced.

The data-driven processing technique may comprise a physics informed machine learning (PIML) model.

Thereby, a data-driven processing technique can be used to determine the at least one parameter and the at least one uncertainty measure in a manner which embeds at least one physical relationship with which the at least one parameter complies, such as a PDE, in particular a linear PDE, or other differential equation.

The PIML model may be trained using a loss function that includes a term dependent on a residual of the PDE and a regularization term that is dependent on the at least one uncertainty measure.

Thereby, the PIML provides output that complies with the physical relationship embedded in the PIML (by virtue of the loss function term that is dependent on the PDE residual) and that punishes uncertain output (by virtue of the loss function term that is a regularization term dependent on the at least one uncertainty measure). This enforces that physically reasonable solutions are identified by the data driven processing technique, with the solutions having, for at least some regions of the asset (e.g., for at least some regions of an asset tank wall), a small uncertainty.

The PIML model may be operative to provide the at least one parameter and the at least one uncertainty measure.

Thereby, the PIML model is operative to determine both the one or several parameters and the at least one uncertainty measure. This facilitates determining the one or several parameters in such a manner that the physical relationship embedded in the PIML model (such as a heat diffusion equation) is complied with, while penalizing regions with a high uncertainty measure.

The PIML model may be operative to perform a probabilistic processing to predict both a mean or average value and a variance of other uncertainty measure for a probability distribution of the at least one parameter. A PDE residual of the PIML model may be determined based on the mean or average value. The variance or other uncertainty measure may be used for determining which action is to be taken based on the uncertainty measure, e.g., by identifying regions from which the mean or average values of the at least one parameter can be extrapolated or interpolated to other regions having reduced PIML model prediction reliability.

Thereby, the PIML model is operative to determine both the one or several parameters and the at least one uncertainty measure in a manner that makes the uncertainty measure available for further use (e.g., in generating an alert, alarm, or triggering a control action that acts on primary system equipment of the electric power system).

The PIML model may have an output operative to output a first parameter (such as temperature) for each one of a plurality of spatial locations, a second parameter (such as heat) for each one of the plurality of spatial locations, and an uncertainty measure for the first parameter and/or and an uncertainty measure for the second parameter for each one of the plurality of spatial locations. The PIML model may be operative to provide these values at an output for each one of a plurality of times.

Thereby, the PIML model is operative to determine both the one or several parameters and the at least one uncertainty measure in a spatially resolved manner, optionally in a manner that has spatiotemporal (both spatial and temporal) resolution. This facilitates determining the one or several parameters in a spatially resolved manner such that the physical relationship embedded in the PIML model (such as a heat diffusion equation) is complied with, while quantifying uncertainty.

The PIML model may have an input operative to receive spatial coordinates, time, measurements (such as thermal measurements), and at least one operating condition (such as a load current) for the asset.

Thereby, the determination of the at least one parameter and the uncertainty measure is facilitated for situations in which the at least one parameter and the uncertainty measure may be dependent on the operating condition. For illustration, determination of heat and/or temperature in a spatially or spatiotemporally resolved manner is facilitated, with the PIML receiving inter alia the asset load current at the input.

The PIML model may comprise a first plurality of neural network (NN) layers having a first input layer, a second plurality of NN layers operative to process a first output of the first plurality of NN layers and having a second output to provide the at least one parameter, and a third plurality of NN layers operative to process the first output of the first plurality of NN layers and having a third output to provide the at least one uncertainty measure.

Thereby, training of the PIML model is facilitated. The portions of the PIML that determine the at least one parameter and the at least one uncertainty measure share several hidden layers (the first plurality of NN layers).

The PIML model may be operative to provide a first parameter and a second parameter, wherein the PIML model embeds a PDE that is dependent on the first parameter and the second parameter.

Thereby, the PIML model is operative to determine several parameters that are interrelated with each other by means of a physical relationship (such as a thermal diffusion equation). Robustness and reliability is enhanced thereby. In particular, the PIML model enforces that physically reasonable solutions are found for the first and second parameters, by virtue of the PDE embedded in the PIML model. As will be appreciated by the skilled artisan, embedding the PDE into the PIML model is attainable by training the PIML with a loss function that includes a loss function term dependent on the PDE residual.

The PDE may be a linear PDE. The PDE may be a PDE that includes a first order partial time derivative and at least two second order partial spatial derivatives (such as a 2D or 3D Laplace operator) of the first parameter and/or the second parameter.

Thereby, the PIML model is operative to determine several parameters that are linked to each other by a diffusion type PDE.

The PDE may comprise a thermal diffusion relationship.

Thereby, the method is operative to determine temperature and/or heat and an uncertainty measure for temperature and/or heat in a spatially resolved manner, optionally in a spatiotemporally resolved manner. This is useful for identifying asset conditions that are associated with local heat and temperature increases, as may be the case for local losses.

The asset may comprise a tank having a tank wall. The data may comprise thermal measurement data obtained at and/or within the tank wall.

Thereby, the method is operative to determine temperature and/or heat and an uncertainty measure for temperature and/or heat in a spatially resolved manner, optionally in a spatiotemporally resolved manner. This is useful for identifying asset conditions that are associated with local heat and temperature increases, as may be the case for local losses.

The at least one parameter may comprise a temperature and/or heat.

Thereby, the method is operative to determine temperature and/or heat and an uncertainty measure for temperature and/or heat in a spatially resolved manner, optionally in a spatiotemporally resolved manner. This is useful for identifying asset conditions that are associated with local heat and temperature increases, as may be the case for local losses.

The tank wall may have a bottom surface, several side surfaces, and a cover. The data may comprise thermal measurement data obtained at least for two or more (optionally all of the several side surfaces). The data may also comprise thermal measurement data obtained for the cover.

Thereby, data that can be readily captured on the portions of a transformer is utilized to obtain a more thorough determination of possible local losses than obtainable based on, e.g., measurements that are performed at a single tank wall only. This is beneficial for reducing the uncertainty measure and modelling thermal behavior along several of the tank sidewalls and, optionally, the cover.

Performing the determination may comprise preprocessing, by the at least one processing circuit, the measurements to generate the input data.

Thereby, the measurements can be preprocessed so as to ensure robustness against variations in measurement instrumentation (such as different thermal camera attitude and/or position) and/or increase reliability of the determined parameter(s).

Preprocessing the measurements may comprise applying a coordinate transform to transform coordinates of pixel or voxel values comprised by the measurements to a world coordinate system of the asset.

Thereby, variations in attitude and/or location of measurement instrumentation (such as a thermal camera or other thermal sensors) relative to the tank wall may be compensated. Increased robustness and reliability is attained.

Alternatively or additionally, the preprocessing may comprise performing a segmentations of at least one array of pixel or voxel values comprised by the measurements to identify zones in which the measurements are unreliable.

Thereby, measurements for areas in which the measurements have reduced value for the data-driven processing technique (e.g., because of the presence of structural tank components, such as tank reinforcements, e.g., tank bars) may be removed from consideration by the preprocessing. This may comprise a cropping of the pixel or voxel arrays. This has the further technical advantage that regions in which, e.g., thermal measurements are made unreliable by the presence of tank reinforcements can be identified from the thermal measurement data themselves. Cropping reduces the risk of artefacts at the regions where the tank reinforcements might otherwise lead to discontinuities in temperature measurements (caused by increased thermal shielding of the tank reinforcements).

Alternatively or additionally, the preprocessing may comprise determining pixel or voxel values for zones in which structural components of the asset reduce the reliability of the measurements, comprising an interpolation, extrapolation, or a regression technique.

Thereby, measurements for areas in which the measurements have reduced value for the data-driven processing technique (e.g., because of the presence of structural tank components, such as tank reinforcements, e.g., tank bars) may be replaced by more reliable substitute data obtained using interpolation, extrapolation, or a regression technique.

The measurements may comprise spatially resolved thermal measurements.

Thereby, local temperature increase and/or heat increase may be identified as a function of position, e.g., on a tank wall of the asset. This facilitates the identification of potential issues with asset operation, which can be used to trigger an alert, alarm, or control action acting on electric power system equipment, based on the at least one parameter and the at least one uncertainty measure.

The processing using the data-driven processing techniques may be operative to enable that the spatial thermal conditions of the asset can be determined also for regions in which no reliable measurements are available (e.g., due to the presence of structural components of the asset tank). The processing using the data-driven processing technique may be operative to enable that the uncertainty of determined temperatures and/or heat values, as quantified by the at least one uncertainty measure, may be determined as a spatially varying uncertainty measure (e.g., a variance of a Gaussian or other probability distribution for temperature or heat, determined in a spatially resolved manner).

The spatially resolved thermal measurements may be received from measurement instrumentation, which may comprise one, several, or all of: at least one thermal camera, at least one thermocouple, at least one fiber optic sensor operative to sense temperature.

Thereby, input for the PIML model may be generated based on such thermal measurements. The PIML model may then be operative to determine not only the heat but also the uncertainty measure for temperature and/or heat.

The data-driven processing technique may be operative to model thermal dynamics in the asset, taking into account thermal diffusion, in a spatially resolved manner along at least two spatial directions.

Thereby, thermal effects may be embedded in the data-driven processing technique (e.g., by means of a PIML model that has the thermal diffusion equation embedded therein). The identification of local losses is facilitated by determining temperature and/or heat as a function of position along at least the plane of one or several sidewalls of an asset tank. Additional information is obtained, which is useful for determining which output is to be generated. For illustration, based on the location of a temperature buildup identified based on a 2D thermal diffusion model embedded in the data driven processing technique, it is possible to determine which one of the following actions is to be performed: alert generation; alarm generation; triggering a control command affecting primary system equipment of the electric power system.

The output may comprise output for an operator interface of the electric power system.

Thereby, the determined at least one parameter and the determined at least one uncertainty measure can be used for alert and/or alarm generation. The method may, thus, be an operation method of an alert and/or alarm generation system, with an alarm or alert being selectively raised based on the determined at least one parameter and the determined at least one uncertainty measure.

Alternatively or additionally, the output may comprise output that triggers at least one control action within the electric power system. The control action may affect primary system equipment, e.g., by changing an asset load current and/or asset load power, by operating a protective device (such as a circuit breaker or switch), changing a tap changer position, or other control operations.

The asset may have a tank wall, wherein the input data for the data driven processing technique may be generated based on measurements obtained for the tank wall of the asset.

Thereby, measurements that can be acquired from an outer side of the tank wall may be used in the processing method. This reduces the risk of measurement instrumentation within the tank wall introducing potential issues within the tank.

The tank wall may contain therein an insulating fluid, such as an insulation oil.

Thereby, the techniques disclosed herein can be harnessed in association with oil insulated assets.

A method of controlling an electric power system according to an embodiment comprise performing, by a processing system, the method of any one aspect or embodiment disclosed herein to predict local losses in the asset of the electric power system, and performing, by the processing system or a control system operatively coupled with the processing system, at least one control operation based on the output.

Thereby, the techniques disclosed herein are used for automatically performing control operations.

A training method of training a PIML model for use in the method of any one aspect or embodiment disclosed herein is provided. The method comprises obtaining training data comprising measurements captured on a tank wall of the asset, and training the PIML model, wherein a loss function minimized in the training may comprise a regularization term that is dependent on the at least one uncertainty measure.

Thereby, a regularization is introduced in the PIML model training which penalizes higher uncertainty over lower uncertainty. The PIML model is, thus, trained to provide spatiotemporal values for the parameter(s) (such as temperature and/or heat) that have low uncertainty measure where possible, with the spatiotemporal values also taking into account the physical relationship governing the parameter(s) (such as a thermal diffusion equation).

The training method may be performed automatically by a computing system.

The loss function may comprise a term that is dependent on a residual of a PDE embedded in the PIML model (such as a residual of the thermal diffusion equation).

Thereby, the PIML model is trained to provide spatiotemporal values for the parameter(s) (such as temperature and/or heat) that comply with the PDE embedded in the PIML model.

The training method may be performed using measurements captured on an asset having identical or similar construction as the asset for which the PIML model is to be used during inference.

Thereby, the PIML model can be trained using measurements captured during a factory test phase.

The training method may be performed using measurements captured on the asset for which the PIML model is to be used during inference.

Thereby, the PIML model can be trained using measurements captured during, e.g., a factory test phase.

The measurements used in the PIML model training may comprise thermal measurements captured in a spatiotemporally resolved manner.

Thereby, the thermal dynamics observed during, e.g., a factory test can be used for training the PIML model.

The measurements used for the training may comprise thermal camera images. The thermal camera images may comprise a sequence of thermal camera images, such as at least 50 or at least 100 thermal camera images.

Thereby, the PIML model can be trained using a series of thermal camera images captured in, e.g., a factory test setting.

The training method may comprise performing, by the computing system, thermal modelling of the asset, to establish a ground truth for heat data in the PIML model training.

Thereby, heat data that may be challenging to measure can be established using thermal modelling in the training phase. It is not required to perform the thermal modelling during inference, as the knowledge of the thermal diffusion equation is embedded in the PIML model as trained.

The PIML model may be operative to provide the at least one parameter and the at least one uncertainty measure.

Thereby, the PIML model is trained such that it is operative to determine both the one or several parameters and the at least one uncertainty measure. This facilitates determining the one or several parameters in such a manner that the physical relationship embedded in the PIML model (such as a heat diffusion equation) is complied with, while penalizing regions with a high uncertainty measure.

The PIML model may be operative to perform a probabilistic processing to predict both a mean or average value and a variance of other uncertainty measure for a probability distribution of the at least one parameter. A PDE residual of the PIML model may be determined based on the mean or average value. The variance or other uncertainty measure may be used for determining which action is to be taken based on the uncertainty measure, e.g., by identifying regions from which the mean or average values of the at least one parameter can be extrapolated or interpolated to other regions having reduced PIML model prediction reliability.

Thereby, the PIML model is trained such that it is operative to determine both the one or several parameters and the at least one uncertainty measure in a manner that makes the uncertainty measure available for further use (e.g., in generating an alert, alarm, or triggering a control action that acts on primary system equipment of the electric power system).

The PIML model may have an output operative to output a first parameter (such as temperature) for each one of a plurality of spatial locations, a second parameter (such as heat) for each one of the plurality of spatial locations, and an uncertainty measure for the first parameter and/or and an uncertainty measure for the second parameter for each one of the plurality of spatial locations. The PIML model may be operative to provide these values at an output for each one of a plurality of times.

Thereby, the PIML model is trained such that it is operative to determine both the one or several parameters and the at least one uncertainty measure in a spatially resolved manner, optionally in a manner that has spatiotemporal (both spatial and temporal) resolution. This facilitates determining the one or several parameters in a spatially resolved manner such that the physical relationship embedded in the PIML model (such as a heat diffusion equation) is complied with, while quantifying uncertainty.

The PIML model may have an input operative to receive spatial coordinates, time, measurements (such as thermal measurements), and at least one operating condition (such as a load current) for the asset.

Thereby, the PIML model is trained such that it is operative to perform the determination of the at least one parameter and the uncertainty measure for situations in which the at least one parameter and the uncertainty measure may be dependent on the operating condition. For illustration, determination of heat and/or temperature in a spatially or spatiotemporally resolved manner is facilitated, with the PIML model receiving inter alia the asset load current at the input.

The PIML model may comprise a first plurality of neural network (NN) layers having a first input layer, a second plurality of NN layers operative to process a first output of the first plurality of NN layers and having a second output to provide the at least one parameter, and a third plurality of NN layers operative to process the first output of the first plurality of NN layers and having a third output to provide the at least one uncertainty measure.

Thereby, training of the PIML model is facilitated. The portions of the PIML model that determine the at least one parameter and the at least one uncertainty measure share several hidden layers (the first plurality of NN layers).

The PIML model may be operative to provide a first parameter and a second parameter, wherein the PIML model embeds a PDE that is dependent on the first parameter and the second parameter.

Thereby, the PIML model is trained such that it is operative to determine several parameters that are interrelated with each other by means of a physical relationship (such as a thermal diffusion equation). Robustness and reliability is enhanced thereby. In particular, the PIML model enforces that physically reasonable solutions are found for the first and second parameters, by virtue of the PDE embedded in the PIML model. As will be appreciated by the skilled artisan, embedding the PDE into the PIML is attainable by training the PIML model with a loss function that includes a loss function term dependent on the PDE residual.

The PDE may be a linear PDE. The PDE may be a PDE that includes a first order partial time derivative and at least two second order partial spatial derivatives (such as a 2D or 3D Laplace operator) of the first parameter and/or the second parameter.

Thereby, the PIML model is operative to determine several parameters that are linked to each other by a diffusion type PDE.

The PDE may comprise a thermal diffusion relationship.

Thereby, the PIML model is trained such that it is operative to determine temperature and/or heat and an uncertainty measure for temperature and/or heat in a spatially resolved manner, optionally in a spatiotemporally resolved manner. This is useful for identifying asset conditions that are associated with local heat and temperature increases, as may be the case for local losses.

The training method may comprise providing PIML model data obtained in the training for use in the method of processing the measurements and/or controlling an electric power system according to any aspect or embodiment.

Thereby, the PIML model as trained with the training method is made available for use in asset monitoring and/or electric power system control.

A processing system according to an embodiment comprises at least one interface operative to receive data comprising measurements for several different measurement locations at or in proximity to an asset of an electric power system. The processing system comprises at least one processing circuit operative to perform a determination of at least one parameter of the asset, comprising applying a data-driven processing technique to input data that are based on the measurements to determine the at least one parameter and at least one uncertainty measure for one or several parameters of the at least one parameter. The processing system is operative to generate output based on the determination.

Thereby, the processing system is operative to determine additional information comprising the at least one uncertainty measure for use in generating an output, such as an alert, warning, or other data (such as a control command) that acts on the electric power system.

The processing system may comprise or may be an alert and/or alarm generation system operative to generate an alert and/or alarm based on the determination. The processing system may comprise or may be a control system operative to perform a control action (e.g., a control action affecting primary electric power system equipment) based on the determination.

The processing system may be operative to perform the method of any aspect or embodiment disclosed herein. The processing system may comprise or may be communicatively coupled to a storage system having stored therein parameters of the data-driven processing technique. The processing system may be operative to provide the output via the at least one interface.

An electric power system comprises an asset, measurement instrumentation operative to obtain measurements for several different measurement locations at or in proximity to the asset, and the processing system according to an aspect or embodiment operative to process data acquired using the measurements.

Thereby, the technical effects of the processing system and method discussed herein are used for enhanced asset monitoring and/or control for the electric power system.

The electric power system may comprise an electric power generation, transmission, and/or distribution system.

Thereby, the technical effects of the processing system and method discussed herein are used for enhanced asset monitoring and/or control in systems in which conventional processing techniques have shortcomings.

The electric power system may comprise an electric power transmission and/or distribution grid.

Thereby, the technical effects of the processing system and method discussed herein are used for enhanced asset monitoring and/or control in systems in which conventional processing techniques have shortcomings.

The electric power system may comprise a high voltage direct current (HVDC) system. The electric power system may comprise a an inverter/converter comprising insulated gate bipolar transistor (IGBT)- or thyristor-based valves.

Thereby, the technical effects of the processing system and method discussed herein are used for enhanced asset monitoring and/or control in systems in which conventional processing techniques have shortcomings.

According to further embodiments, there is provided machine-readable instruction code which, when executed by at least one programmable circuit, causes the at least one programmable circuit to perform the processing method, the control method, or the operation method according to any aspect or embodiment disclosed herein.

According to further embodiments, there is provided a non-transitory storage medium having stored thereon machine-readable instruction code which, when executed by at least one programmable circuit, causes the at least one programmable circuit to perform the processing method, the control method, or the operation method according to any aspect or embodiment disclosed herein.

Various effects and advantages are attained by embodiments of the invention. For illustration, the processing systems and methods according to embodiments provide enhanced techniques useful in association with asset monitoring and/or electric power system control. The processing systems and methods determine at least one uncertainty measure for one or several determined parameters, facilitating the automatic determination of which action is to be taken based on the processing of the measurements.

The processing system and method are operative to determine heat and/or temperature in a spatiotemporally resolved manner along at least several sidewalls of an asset tank, taking into consideration thermal diffusion. The identification of local losses in an asset is facilitated thereby.

The processing system and method can be used in association with an electric power grid or subsystems thereof, without being limited thereto.

BRIEF DESCRIPTION OF THE DRAWINGS

Embodiments of the invention will be described with reference to the drawings in which similar or identical reference signs designate elements with similar or identical configuration and/or function.

Figure 1 is a schematic view of a system comprising a processing system.
Figure 2 is a schematic representation of processing performed by the processing system.
Figure 3 is a schematic representation of a physics informed machine learning (PIML) model that may be implemented by the processing system.
Figure 4 is a schematic representation of a PIML model that may be implemented by the processing system.
Figure 5 is a schematic representation of a PIML model that may be implemented by the processing system.
Figure 6 is a schematic representation of a PIML model that may be implemented by the processing system.
Figure 7 is a flow chart of a method.
Figure 8 is a schematic representation of processing performed by the processing system.
Figure 9 is a flow chart of a method.
Figure 10 shows measurements processed by the processing system.
Figure 11 shows results of a preprocessing performed by the processing system.
Figure 12 shows results of additional preprocessing performed by the processing system.
Figure 13 shows results obtained using a physics-informed processing technique.
Figure 14 shows results obtained directly from measurements.
Figure 15 shows an uncertainty measure obtained using the physics-informed processing technique.
Figure 16 illustrates a temperature probability distribution.
Figure 17 illustrates a further temperature probability distribution.
Figure 18 is a flow chart of a method.
Figure 19 is a flow chart of a method.
Figure 20 is a flow chart of a method.
Figure 21 is a flow chart of a method.

Figure 22 is a schematic view of a further system comprising the processing system.
Figure 23 is a graph showing an uncertainty measure for different numbers of measurement locations.
Figure 24 is a graph showing a variance of a mean temperature for different numbers of measurement locations.
Figure 25 is a flow chart of a method.
Figure 26 is a schematic view of a further system comprising the processing system.
Figure 27 is a schematic view of a further system comprising the processing system.
Figure 28 is a schematic view of a further system comprising the processing system.
Figure 29 is a schematic view of a further system comprising the processing system.
Figure 30 is a schematic view of a further system comprising the processing system.

DETAILED DESCRIPTION OF EMBODIMENTS

Embodiments of the invention will be described with reference to the drawings. In the drawings, similar or identical reference signs designate elements with similar or identical configuration and/or function.

Embodiments relate to processing systems and methods operative to determine one or several parameters of an electric power system in a spatially resolved manner, optionally in a spatiotemporally resolved manner, and to determine an uncertainty measure for at least one of the parameters in a spatially resolved manner, optionally in a spatiotemporally resolved manner.

The processing systems and methods are operative to perform a data-driven processing technique that has physical knowledge embedded therein to determine the parameter(s) and uncertainty measure(s). The data-driven processing technique may comprise a physics informed machine learning (PIML) model, such as a physics informed neural network (PINN). The PIML model may have an output operative to provide the parameter(s) and the uncertainty measure(s). The PIML model may have an input operative to receive input data that include a location and, optionally, time for which the parameter(s) are to be determined, measurements (such as thermal measurements) for locations for which measurements are available and/or at least one operating parameter (such as a load power and/or load current).

While embodiments will be described in detail primarily in association an electric power system that comprises a power transmission and/or power distribution system, the embodiments are not limited thereto.

Processing methods and systems disclosed herein are operative to process measurements obtained for an asset that has a tank, such as a transformer or shunt reactor comprising a tank that may be filled with an insulation fluid (e.g., an insulation oil). The data-driven processing technique may be operative to process measurements obtained at least on one or several sidewalls of the tank. The data-driven processing technique may be operative to determine temperature and/or heat and an uncertainty measure for at least one of temperature and/or heat in a spatially resolved, optionally a spatiotemporally resolved, manner. The processing system may then be operative to generate output based on the determined spatially resolved temperature and/or heat, and uncertainty measure of temperature and/or heat.

As used herein, the term "electric power system" encompasses an electric power generation, transmission, and/or distribution system, e.g., an electric power grid or parts thereof.

As used herein, the term "power grid" encompasses a power transmission grid and/or a power distribution grid. The power grid may comprise both a power transmission grid and a power distribution grid.

As used herein, the term "measurements" may encompass event-based data (e.g., GOOSE messages). The processing system may be operative to receive the measurements from measurement instrumentation and/or from secondary system components (e.g., intelligent electronic devices (IEDs)) of the electric power system.

As used herein, the term "uncertainty measure" encompasses a value that quantifies the uncertainty in a parameter as determined using the data-driven processing technique. The uncertainty measure may quantify or may otherwise be indicative of a variance of a probability distribution for the parameter (e.g., a variance of a probability distribution for heat or for temperature). The uncertainty measure will typically be spatially varying. The processing system disclosed herein may be operative to determine the uncertainty measure for a plurality of locations, e.g., on sidewalls of a tank of an asset. The term "uncertainty measure" as used herein encompasses measures that quantify confidence, it being understood that increased uncertainty is associated with reduced confidence and vice versa. For simplicity, reference will mostly be made to an uncertainty herein, it being understood that the techniques disclosed herein remain operative for a wide variety of uncertainty measures, including some that quantify confidence rather than uncertainty.

For reasons of stability, the uncertainty measure may be equal or proportional to a logarithm of a variance of a probability distribution (e.g., a Gaussian probability distribution) for the respective parameter at the respective location.

A data-driven processing technique that is operable to determine both at least one parameter and at least one uncertainty measure may be operative to provide, as an output, both the at least one parameter and the at least one uncertainty measure. Techniques that allow implementation of such a data-driven processing technique are discussed in detail herein.

As used herein, an "operating parameter" that may be received at an input of the data-driven processing technique (e.g., at a PIML model input) may be any operating parameter that influences the parameter(s) determined using the data-driven processing technique. For illustration, load power and/or load current are examples of operating parameters that are useful when applying the techniques disclosed herein for temperature-based asset monitoring applications operable to identify local losses and trigger appropriate action responsive thereto.

The techniques disclosed herein are operable to not only determine several parameters that are interrelated by means of a physics relationship (such as a diffusion type relationship), but to also quantify confidence (and, thus, uncertainty) for the determined parameter in a spatially, optionally spatiotemporally, resolved manner.

The techniques disclosed herein may comprise a preprocessing for converting data received by the processing system into PIML model input suitable to be input to a PIML model.

The preprocessing may comprise a transformation of thermal camera output to map pixel coordinates to world coordinates of an asset coordinate frame.

The preprocessing may comprise using a separate mesh for structural components (such as pillars) of a tank of the asset where the measurements are not reliable.

The preprocessing may comprise removing pixels near boundaries of strips and an interpolation or extrapolation to ensure continuity in heat diffusion.

The PIML model and methods may be operative to handle unreliable data in PIML model training. This may comprise any one or any combination of: training the PIML model without the unreliable data; training the PIML model with reliable temperature data and learning to interpolate into the unreliable regions by using the knowledge of underlying PDE, which weakly enforces consistency between temperature and heat source estimates; and/or compensating for a limited amount of reliable measurement data (e.g., using multiple types of measurement device, generative modeling to create realistic and physically sound synthetic data from local simulations).

The processing systems and method may be operative to increase explainability of the PIML model. A probabilistic PIML model may be used to estimate the mean and variance of a prediction (e.g., temperature and/or heat), which provides a quantitative measure for the PIML model confidence in different parts of the tank geometry. Regions of low confidence (as identified by the uncertainty measure) indicate unreliable data source (i.e., temperature fields not representative of the heat diffusion). The uncertainty measure indicator is used as metric to choose the optimal locations of pointwise sensors (thermocouples, fiber optics sensors, ...) to reduce uncertainty of the estimate(s).

The processing system and method are operative such that the data driven processing technique provides robustness with data sparsity. The uncertainty can be separated into PIML model and measurement uncertainty. Thereby, the processing system and method are operative to determine to which extent the density of thermal measurement locations affects the PIML model output. Thus, the processing system and method may be used to determine changes to the measurement instrumentation (such as sensor placement) that can be performed to further increase performance of the asset monitoring.

Various effects and advantages are associated with the processing methods and systems. For illustration, the processing systems and methods may be operative to provide parameter predictions that have enhanced robustness as compared to conventional techniques. The uncertainty measure(s) can be used in various ways to generate output, such as by adding explainability to the parameter prediction(s), identifying spatial regions in which parameter estimates can be improved by extrapolation or interpolation from spatial regions having lower uncertainty, and/or by determining whether a local loss identified in the asset based on the predicted parameter(s) is identified so reliably (based on the associated uncertainty measure) that a control action is to be performed automatically.

The processing systems and methods may be operative to utilize PIML. PIML is an emerging area in Machine Learning (ML), where underlying physics of a system is estimated in association with the observed data, making the trained model less dependent on data since it learns to predict from the dynamics directly, compared to purely data-driven processes. The neural networks (NNs) (such as deep or shallow NN) that are trained to estimate the dynamics along with the observed variables are called Physics-Informed Neural Networks (PINNs) and they can be used to predict variables by learning from a fully known dynamics (forward problem) or estimating unknown or uncertain components of a partially known dynamics (inverse problem). Due to its capability of estimating dynamics using limited observations, PINNs can be leveraged to estimate the dynamics in complex devices, where the dynamics is partially known, simulation is difficult or impossible due to lack of knowledge of the physical model or data measurements are costly.

The processing systems and methods address the challenge that, in some real-life applications, data availability as obtainable by measurements may be limited and/or the quality of the data may not be sufficiently good. An example is the influence of structural components of an asset tank (such as tank reinforcements) on temperature measurements. The processing systems and methods also address the limitation that conventional techniques, even when based on physics informed data-driven processing, may not adequately consider the uncertainty of the output.

The processing systems and methods provide techniques in which PIML (e.g., a PINN) can be used to estimate heat diffusion in complex electromagnetic devices such as a power transformers or a shunt reactor in the presence of limited and/or unreliable measurements. To that end, the processing systems and methods may be operative to perform a preprocessing to generate input to a PIML model. The processing systems and methods are operative to quantify the uncertainty of the model's output for each point of the geometry of the device under study. Compared to other approaches, this spatial uncertainty measure provides explainability in the sense that it provides guidance on where measurements are insufficient. This may be operative to determine what modification of the measurement instrumentation is to be implemented. The data driven processing techniques also provide robustness with data sparsity, which indicates that the techniques disclosed herein remain operative even when limited data is available.

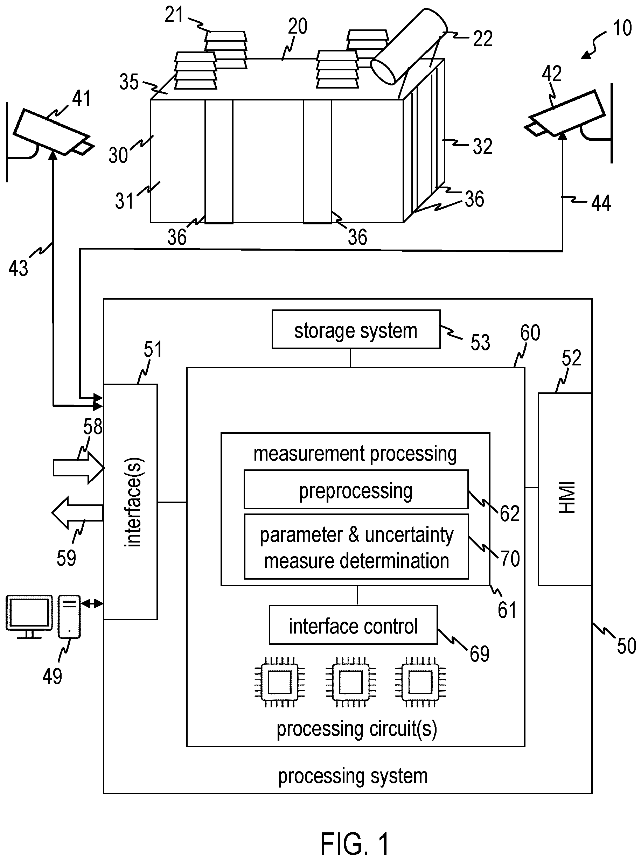

Figure 1 shows a schematic representation of a system 10. The system 10 comprises an asset 20 of an electric power system, measurement instrumentation 41, 42, and a processing system 50 operative to process the measurements. The processing system 50 is operative to perform a data-driven processing technique to determine one or several parameters, such as temperature and heat, in a spatially resolved, optionally a spatiotemporally resolved, manner. The processing system 50 is further operative to perform the data-driven processing technique to determine an uncertainty measure for at least one of the one or several parameters. The uncertainty measure may be determined in a spatially resolved manner.

The asset 20 has a tank 30. The tank 30 has a plurality of sidewalls 31, 32, a cover 35, and a bottom (which is hidden from view in Figure 1). The asset 20 may have structural components such as tank reinforcements 36 disposed along at least parts of the tank wall. The structural components may reduce the significance of thermal measurements at the locations at which the structural components are provided and in adjacent regions of the tank wall. The asset 20 may have accessory components such as bushings 21 and an expansion tank 22. The tank 20 may be filled with an insulation liquid, such as an insulation oil. The expansion tank 22 may be operative to receive oil from the tank 20 with which it is fluidically connected. Thereby, it can be ensured that a sufficient amount of oil is present within the tank 20 even as the density of the oil varies due to thermal influences.

The measurement instrumentation may comprise one or several sensors operative to sense temperature at a plurality of locations at the tank wall of the tank 30. The measurement instrumentation may be operative to sense temperature or quantities indicative of the temperature in a spatially resolved manner for at least two sidewalls 31, 32 and, optionally, the cover 35. The measurement instrumentation may comprise at least one thermal camera 41, 42. The measurement instrumentation may comprise one or several of thermal cameras 41, 42 operative to perform measurements on at least two sidewalls 31, 32 of the tank 30. The measurement instrumentation may additionally or alternatively comprise other sensors, such as optical of fiber optical sensors operative to measure temperature, thermocouples, or other temperature sensing equipment.

The processing system 50 comprises at least one interface 51. The at least one interface 51 is operative to receive data based on the measurements captured by the measurement instrumentation. The at least one interface 51 may be communicatively interfaced with the measurement instrumentation over at least one communication link 43, 44. The at least one communication link 43, 44 may be a unidirectional or bidirectional communication link. In the latter case, the processing system 50 may be operative to control the measurement instrumentation to perform the measurements.

Generally, the at least one interface 51 of the processing system 50 may be operative to receive data 58 comprising or otherwise based on the measurements. The data 58 may optionally also comprise at least one operating parameter for the asset 20, such as a load current load power. The at least one interface 51 of the processing system 50 may be operative to provide output 59. The output 59 may be based at least on the determined one or several parameters and the at least one uncertainty measure for the one or several parameters.

The processing system 50 generally comprises one or several processing circuits 60 and the at least one interface 51. The processing system 50 may optionally comprise a human machine interface (HMI) 52. The processing system 60 may comprise a storage system 53 or may be communicatively coupled to the storage system 53. The storage system 53 may have stored therein parameters and, optionally, hyperparameters of a data-driven processing technique performed by the processing system 50. The parameters and, optionally, hyperparameters may define a PIML model, such as a PINN, operative to determine the at least one parameter and the at least one uncertainty measure in a spatially resolved manner. The at least one processing circuit 60 may be operative to retrieve the parameters and, optionally, hyperparameters from the storage system 53. The parameters and, optionally, hyperparameters stored in the storage system 53 may be determined in a training. The training may be implemented in such a manner that both a physical relationship is encoded in the trained data-driven processing technique and a regularization is applied in the training which penalizes high uncertainty measures. Thereby, the processing system 50 is operative to apply a data-driven processing technique in a manner which provides physically reasonable solutions (such as spatiotemporal solutions for temperature and heat that take into account a thermal diffusion equation) while prioritizing solutions with low uncertainty measure over solutions with higher uncertainty measure.

The at least one processing circuit 60 is operative to perform a measurement processing 61. The measurement processing 61 may comprise a preprocessing 62. The preprocessing 62 may be operative to transform measurements obtained by the measurement instrumentation 41, 42 into a desired coordinate system (such as a coordinate system fixed to the sidewalls 31, 32 of the tank 30). The preprocessing 62 may also crop measurement regions in which the measurements are expected to have low reliability, such as measurements in regions of the structural components 36.

The at least one processing circuit 60 is operative to perform a determination 70 of both at least one parameter and an uncertainty measure for one or several parameters of the at least one parameter. The at least one processing circuits 60 may be operative such that the determination 70 is operative to determine both heat and temperature in a spatially resolved manner, optionally in a spatiotemporally resolved manner, and to additionally determine an uncertainty measure for at least one of heat and temperature in a spatially resolved manner, optionally in a spatiotemporally resolved manner.

The at least one processing circuit 60 is operative to perform an interface control 69. The interface control 69 is operative to control the at least one interface 51 and/or the HMI 52 to provide output that is based on the determined at least one parameter and the determined uncertainty measure or they determined uncertainty measures.

To perform the stated operations, the at least one processing circuit 60 may comprise any one or any combination of integrated circuits, integrated semiconductor circuits, processors, controllers, application specific integrated circuits (ASICs), field programmable gate arrays (FPGAs), circuit(s) including quantum bits (qubits) and/or quantum gates, without being limited thereto.

The determined at least one uncertainty measure, which may be spatially resolved over at least a portion of the sidewalls 31, 32 of the tank 30, may be used in various ways to generate the output. For illustration, the at least one uncertainty measure may be used to provide output, thereby adding explainability that indicates in which regions the determined temperature and/or heat is deemed reliable. Alternatively or additionally, the at least one uncertainty measure may be used to identify in which spatial zones on the tank 30 the heat and/or temperature determined using the data-driven processing technique is deemed unreliable and from which other regions on the tank 30 heat and/or temperature can be extrapolated or interpolated into the unreliable zones. Alternatively or additionally, the at least one uncertainty measure may be used to determine whether an identified local increase in heat and/or temperature is sufficiently reliable (based on the uncertainty measure for the respective location on the tank wall) that it warrants a control action to be automatically taken.

The at least one interface control 69 may, thus, be operative to control the at least one interface 51 and/or the HMI 52 to provide the output that is dependent inter alia on the at least one uncertainty measure.

The output 59 may comprise control commands or other control data that trigger an action affecting a primary system of the electric power system comprising the asset 20. The processing system 50 may be operative to directly generate and provide control commands. Alternatively or additionally, the processing system 50 may be communicatively interfaced with a control system 49 of the electric power system. The processing system 50 may be operative to generate the output 59 such that it causes the control system 49 to perform an action that affects primary system equipment of the electric power system.

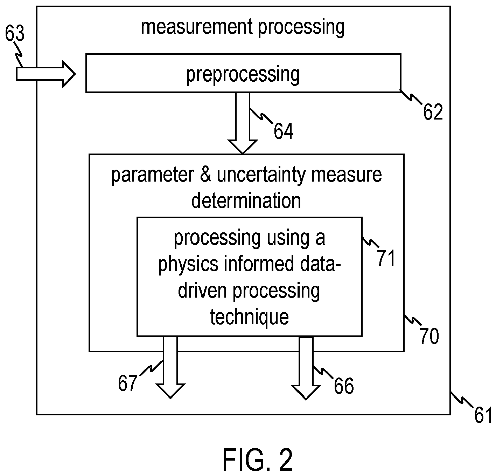

Figure 2 is a schematic block diagram representation of the measurement processing 61. The preprocessing 62 receives input 63 that is based at least on the measurements obtained using the measurement instrumentation. The input 63 may include temperature measurements for a plurality of locations on the tank wall of the tank 30. The preprocessing 62 may perform one or several operations to generate PIML model input 64 based on the input 63. The preprocessing 62 may comprise one or several of a segmentation to identify structural components of the tank wall, which have the potential of rendering thermal measurements unreliable, removing measurements that are deemed to be unreliable (for example due to the presence of structural components of the tank 30), and/or performing operations such as extrapolation, interpolation, or regression to replace measurements that can be identified as being unreliable by substitute data that may be updated from adjacent regions in which the thermal measurements are more reliable.

The determination 70 of the at least one parameter and the at least one uncertainty measure may comprise processing the result of the preprocessing 64 using a physics informed data-driven processing technique 71. The physics informed data-driven processing technique may comprise a PIML model, such as a PINN. As will be described in more detail below, the physics informed data-driven processing technique 71 is operative in such a manner that it determines at least one parameter (such as temperature and/or heat) in a spatially resolved manner and further that it determines an uncertainty measure (such as a variance or other uncertainty measure for temperature and/or heat) in the spatially resolved manner.

The determination 70 is operative to provide, e.g. as an output of the PIML model, the at least one parameter 66 and the at least one uncertainty measure 67. The at least one parameter 66 and the at least one uncertainty measure 67 may be respectively provided for each one of a plurality of locations on at least 2 sidewalls 31, 32 of the tank 30, optionally for a plurality of points in time.

The processing system 50 may be operative to use the PIML model for determine the at least one parameter. The PIML model may also be operative to provide the at least one uncertainty measure.

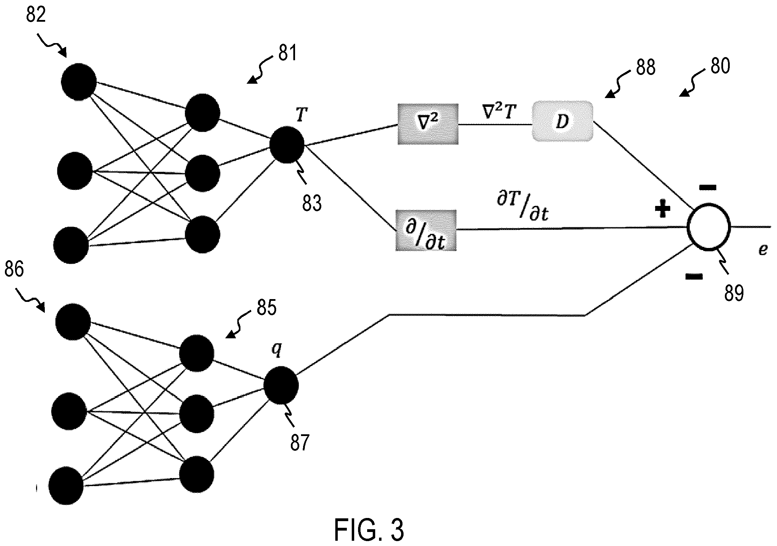

Figure 3, Figure 4, Figure 5, and Figure 6 shows implementations of the PIML model implemented respectively as a PINN.

Figure 3 is a schematic representation of a PIML model 80. The PIML model 80 has an input 82, 86. The PIML model includes a PIML model portion 81 operative to predict a first parameter (such as temperature). The PIML model may include a further PIML model portion 85 operative to predict a second parameter (such as seed) that is related to the first parameter by virtue of a physical relationship. The PIML model 80 may have an output 83 are operative to provide the first parameter. The PIML model 80 may have further output 87 operative to provide the second parameter.

The PIML model 80 is trained in such a manner that it embeds a physical relationship. The physical relationship depends on the first and second parameters. For a thermal diffusion phenomenon, the physical relationship may be a partial differential equation (PDE) that links the first partial time derivative of the temperature, the second partial spatial derivatives of the temperature (such as a 2D or 3D Laplace operator), and the rate of change of heat with each other. This physical relationship embedded in the PIML model 80 is schematically illustrated by means of operators 88 and summation node 89. An output of the summation node 89 provides the residual of the PDE. During training, the PIML model 80 is trained using a loss function that includes a term dependent on the PDE residual. Thereby, the first and second PIML model portions 81, 85 are trained to provide physically meaningful solutions that comply with the thermal diffusion equation.

It will be appreciated that, during inference, it is not required (but still possible) to determine the residual of the PDE. In other words, the operations 88, 89 may be omitted when using the PIML model 80 during inference.

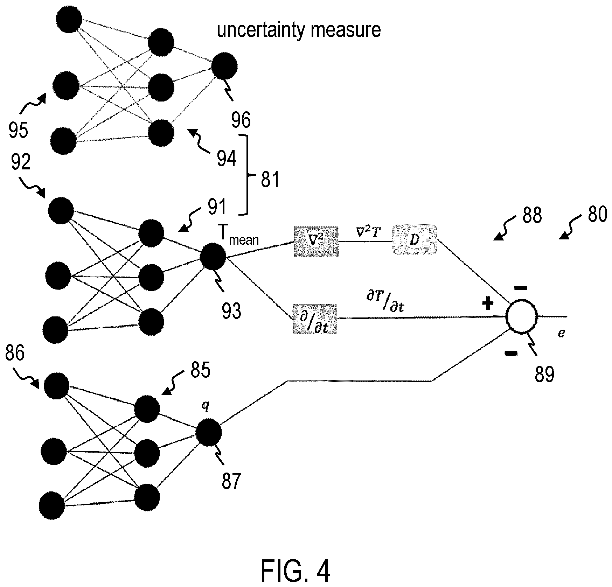

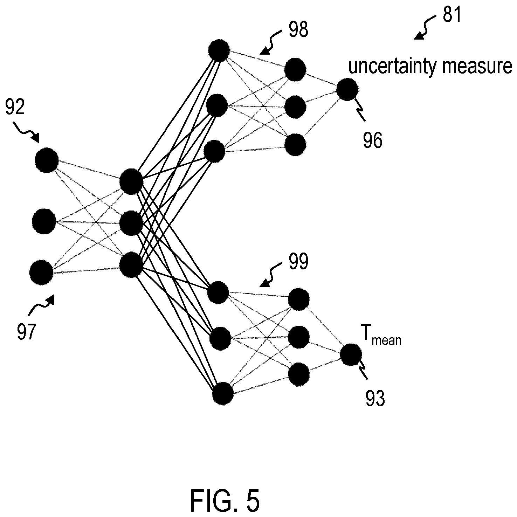

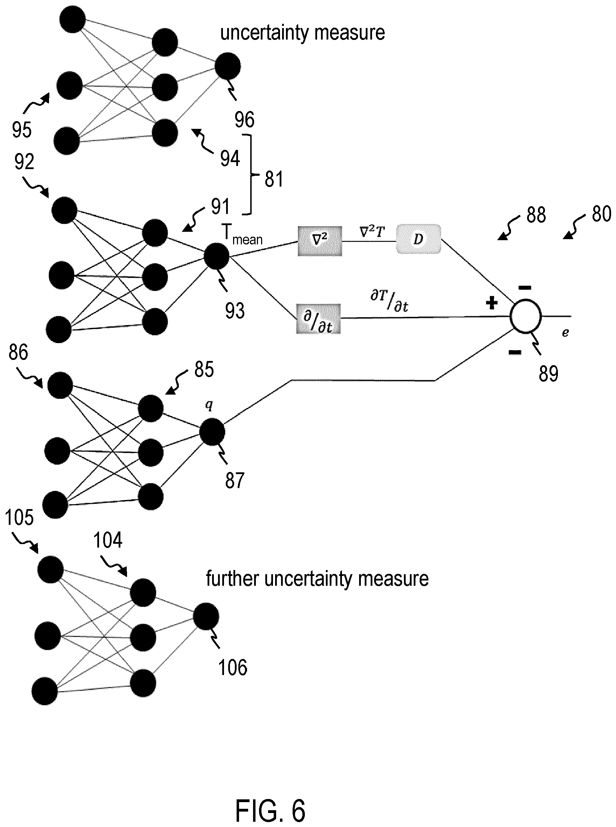

The input nodes 82 may be operative to receive spatial coordinates (such as a pair of coordinates specifying a location on the sidewalls 31, 32 of the asset) and time. When available, temperature for this location and time may be used as a label for the input or may otherwise be provided at the input nodes 82. It should be understood that, while temperature measurements are obtained using the measurement instrumentation, the PIML model 80 and its value because, firstly, it provides a holistic determination of temperature and heat that complies with thermal diffusion, and, secondly, it can also provide at least one uncertainty measure, as will be described in more detail in association with Figure 4, Figure 5, in Figure 6.

The input nodes 86 may be operative to receive spatial coordinates and an operating condition that affects temperature and/or heat. For illustration, the input nodes 86 may be operative to receive spatial coordinates (such as a pair of coordinates specifying a location on the sidewalls 31, 32 of the transformer) and a load power and/or load current.

Temperature and/or heat and the uncertainty measure(s) for temperature and/or heat may be determined in a spatially resolved manner in that the processing system 50 is operative to input various spatial coordinates (e.g., on one or several of the sidewalls and/or cover of the tank 30), optionally with temperature labels where available, and at least one operating parameter (such as load current and/or load power) to the data-driven processing technique.

Temperature and/or heat and the uncertainty measure(s) for temperature and/or heat may be determined in a spatiotemporally resolved manner in that the processing system 50 is operative to input various spatial coordinates (e.g., on one or several of the sidewalls and/or cover of the tank 30), optionally with temperature labels where available, and various times and at least one operating parameter (such as load current and/or load power) for the respective time to the data-driven processing technique. Thereby, temperature and heat can be determined in a spatiotemporally resolved manner using the data-driven processing technique.

Figure 4 shows a schematic representation of a PIML model 80 operative to perform a probabilistic determination in the sense that both a mean or average value of a probability distribution for at least one parameter (such as temperature) and an uncertainty measure (such as variance) are determined. The PIML model 80 has a portion 91 having input nodes 92 and operative to provide the mean or average value at output node 93. During training, it is the mean or average value that is used to determine the PDE residual by means of operations 88, 89. The PIML model 80 has a further portion 94 having input nodes 95 and operative to provide the uncertainty measure at output node 96. The uncertainty measure provided at output node 96 may be used in various ways, such as by automatically assessing the reliability of the mean or average value provided at output node 93. Thus, the processing system 50 may be operative to use the uncertainty measure provided at output node 96 to determine whether the value at output node 93 is to be discarded or replaced by an extrapolation or interpolation from the mean or average values are obtained for the adjacent locations on the asset wall. Alternatively or additionally, the processing system 50 may be operative to use the uncertainty measure provided at output node 96 to determine whether a local loss indicated by the value at output node 93 with sufficiently high confidence that the processing system 50 generates output that automatically triggers a control action.

The input nodes 92, 95 may be operative to receive spatial coordinates (such as a pair of coordinates specifying a location of the sidewalls 31, 32 of the asset) and time. When available, temperature for this location and time may be used as a label for the input 92, 95 or may otherwise be provided to the portion 81 of the PIML model 80 that determines a mean or average value of a parameter (output at node 93) and an uncertainty measure for the parameter (output at node 96).

As explained with reference to Figure 3, the operations 88, 89 to not bias to be performed in using the PIML model 80 during inference. However, training of the PIML model 80 is implemented in such a way that the physical relationship between the various parameters and their derivatives, such as a thermal diffusion, are considered during the training, penalizing physically unreasonable results.

The portions of the PIML model 80 that predict different the parameters and/or that predict a mean or average value and an uncertainty measure for a parameter need not be completely separate. For illustration, the PIML model may have a first number of NN layers operative to process PIML model input, with an output of the first number of NN layers being used to both determine the mean or average value of the parameter and the uncertainty measure for the parameter.

Figure 5 is a schematic representation of a portion 81 of a PIML model that is operative to provide both a mean or average value of a parameter (at node 93) and an uncertainty measure for the parameter (at node 96).

The PIML model portion 81 comprises a first set of an in layers 97 having an input layer 92. The input layer 92 may be operative to receive spatial coordinates and time and, there are available, a thermal measurement for these spatial coordinates and time, which may be included as a label. The PIML model portion 81 comprises a second set of NN layers 98 having an input operative to receive an output of the first set of NN layers 97. The second set of NN layers 98 has output node 96 to provide the uncertainty measure. The PIML model portion 81 comprises a third set of NN layers 99 having an input operative to receive the output of the first set of NN layers 97. The third set of NN layers 99 has output node 93 to provide the average or mean of the parameter.

Such an implementation of portions of the PIML model that predict the mean or average of a parameter and an uncertainty measure for this parameter provide the advantage that training can be performed more efficiently.

Moreover, such an implementation of portions of the PIML model that predict the mean or average of the parameter and an uncertainty measure for the parameter provide the technical benefit of enhanced robustness.

While Figure 4 and Figure 5 illustrate PIML model implementations operative to predict an uncertainty measure for temperature, the PIML model may alternatively or additionally be operative to provide an uncertainty measure for heat or another parameter that is physically related to temperature.

Figure 6 shows an implementation of a PIML model 80 which comprises a portion 104 operative to provide at node 106 an uncertainty measure for heat or heat rate of change. The portion 104 is operative to receive it input 105 spatial coordinates and at least one operating parameter of the asset 20. The portion 104 is operative to provide at node 106 a variance or other uncertainty measure for a heat in the respective location.

While not shown in Figure 6, the PIML model 80 may be configured in such a way that the PIML model portions that predict an average or mean value of a parameter and the associated uncertainty measure may share at least some NN layers, as explained with reference to Figure 5.

The processing system 50 may be operative to provide to the PIML model 80, such as the PIML model 80 explained with reference to any one of Figure 3, Figure 4, Figure 5, and Figure 6, spatial coordinates and, optionally, times and/or load conditions at the respective times for a plurality of locations on the sidewalls 31, 32 of the tank 30 and/or for a plurality of times. Thereby, the at least one parameter and the at least one uncertainty measure may be determined in a spatially resolved manner, optionally in a spatiotemporally resolved manner.

The architecture of the PIML model 80 of Figure 4, Figure 5, and Figure 6 accommodates the determination of both mean and variance in the prediction. This architecture is somewhat related to the ML model architecture discussed in further detail in C. Moya et al., "DeepONet-Grid-UQ: A Trustworthy Deep Operator Framework for Predicting the Power Grid's Post-Fault Trajectories", arXiv:2202.07176, where the confidence is estimated for a deep neural network. However, the PIML model 80 of Figure 4, Figure 5, and Figure 6 is different therefrom in the sense that the PIML model 80 embeds physics knowledge, by being trained so as to learn from the PDE residual. The PIML model's confidence is inversely proportional to the estimated variance, i.e., the model is more confident at the regions where the variance is low, and the model is less confident where the variance is high. This uncertainty measure is useful for various applications, such as enabling a power system operator to gain more insights into the areas that might require more attention during monitoring and/or testing, and/or by performing control actions during field use of the asset based inter alia on the uncertainty measure and its spatial variations.

The PIML model 80 of Figure 4, Figure 5, and Figure 6 may be operative such that, instead of a point prediction of the temperature, a Gaussian distribution of temperature is predicted. In particular, the predicted temperature is assumed to be of the following form

$$T_{pred} = \mathcal{N}(T_{mean}, T_{conf})$$

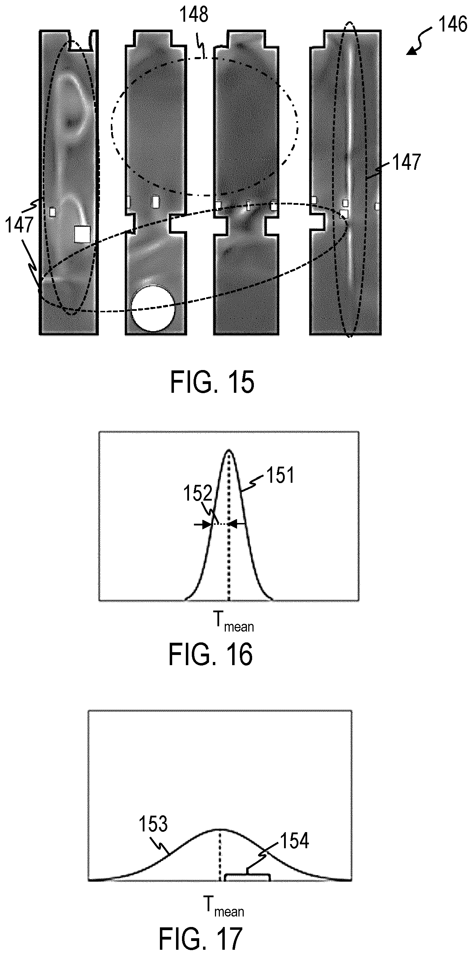

i.e., it is a normal distribution with mean $T_{mean}$ and variance $T_{conf}$, as is shown in Figure 16 and Figure 17. The PIML model 80 of Figure 4, Figure 5, and Figure 6 predicts $T_{mean}$ and $\log T_{conf}$ (the logarithm being taken for numerical stability, and it being understood that the variance is in one-to-one correspondence with its logarithm).

The approach of using a data driven processing technique operative to determine not only a mean or average value of a parameter at a certain location but also an uncertainty measure for the same location (with both being determined in a spatially resolved manner for a plurality of locations on the tank wall) provides various technical benefits:

- The technique provides uncertainty quantification (UQ) without increased complexity (as compared to, e.g., Bayesian networks)
- Probabilistic loss, a term or several terms in the loss function that penalize(s) uncertainty, guides the training so as to avoid overfitting.
- The technique provides confidence during extrapolation to regions where ground truth data is unreliable or unavailable, thus achieving overall better accuracy.
- The uncertainty measure adds explainability by quantifying in which regions the model is confident in its prediction and by quantifying the prediction accuracy. This information is useful for various purposes, such as identifying regions from which temperature(s) can be extrapolated and/or interpolated and/or identifying regions into which temperature(s) and/or other parameter(s) such as heat can be extrapolated or interpolated.

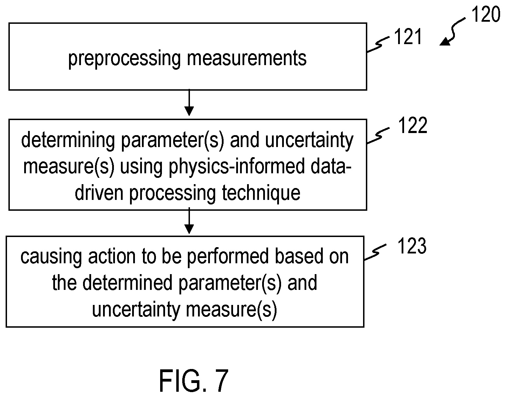

Figure 7 is a flow chart of a method 120. The method 120 may be performed automatically by the processing system 50.

At process block 121, measurements are preprocessed. Preprocessing of the measurements may comprise converting the measurements into a format suitable for provision as input data to a PIML model. Preprocessing may comprise segmentation and/or cropping of thermal images. Preprocessing may comprise an identification of areas in which thermal measurements are unreliable, due to, for example, the presence of structural components of the tank 30 that provide heat sings and/or thermal shielding. Preprocessing may comprise interpolation or extrapolation to facilitate the subsequent processing by the PIML model.

At process block 122, at least one parameter and the at least one uncertainty measure for a parameter of the at least one parameter is determined using a physics informed data-driven processing technique. The at least one parameter and the at least one uncertainty measure may be determined in a spatially resolved manner, optionally in a spatiotemporally resolved manner, for a plurality of locations on, e.g., sidewalls 31, 32 of the tank 30.

At process block 123, the processing system causes at least one action to be performed based on both the determined at least one parameter and the determined at least one uncertainty measure. Causing at least one action to be performed may comprise triggering a warning, alert, or alarm. Alternatively or additionally, causing the at least one action to be performed may comprise generating a control command or control data that triggers a change in operating conditions, such as a change affecting primary system equipment of the electric power system.

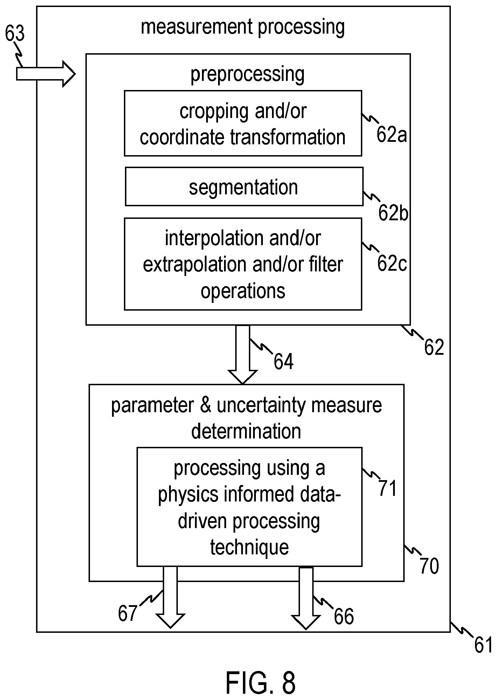

Figure 8 is a schematic representation of a measurement processing that may be performed by the at least one processing circuit 60 of the processing system 50. The measurement 61 comprises the preprocessing 62. The preprocessing 62 may comprise a cropping and/or coordinate transformation of measurement data. For illustration, when using thermal cameras, the preprocessing may comprise a cropping 62a that removes pixels or voxels not representative of any portion of the tank 30 and/or a coordinate transformation 62a that transforms the thermal image to a coordinate frame fixed relative to one or several sidewalls 31, 32 of the tank 30.

The preprocessing 62 may comprise a segmentation 62b. The segmentation 62b may be performed based on the thermal measurements. The segmentation 62b may comprise identifying, based on the measurements, pixels or voxels arranged at structural components of the tank 30 that reduces reliability of the thermal measurements.

The preprocessing 62 may comprise an interpolation, extrapolation, and/or other filter operation 62c. The interpolation, extrapolation, and/or other filter operation is preferably local in the sense that only pixels in a local environment of the pixel that is replaced by an interpolated, extrapolated or other filter value are taking into consideration. Thereby, the local association of measurements and locations on the tank 30 remains available during the subsequent processing using, e.g., a PIML model.

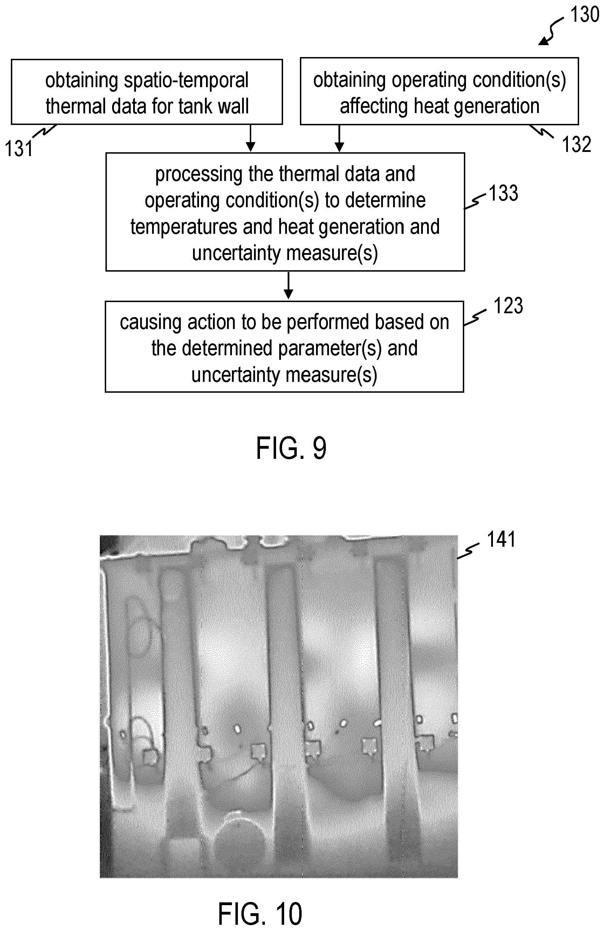

Figure 9 is a flow chart of a method 130. The method 130 may be performed automatically by the processing system 50.

At process block 131, the processing system obtains spatiotemporal thermal data for a wall of a tank of the asset.

At process block 132, the processing system obtains at least one operating condition that affects heat generation in the asset. Load current and/or load power are examples for such operating conditions.

At process block 133, the processing system processes the thermal data and the operating condition(s) to determine temperatures and heat in a spatially resolved manner, optionally in a spatiotemporally resolved manner. The processing system also determines at least one uncertainty measure for temperature and/or heat in a spatially resolved manner, optionally in a spatiotemporally resolved manner. The processing system may use a data-driven processing technique, in particular a PIML model, to perform the processing, as explained with reference to Figure 3, Figure 4, Figure 5, and Figure 6.

At process block 123, the processing system causes at least one action to be performed based on the determined parameters (temperature and/or heat) and the determined uncertainty measure. Process block 123 may be implemented as previously explained with reference to Figure 7.

Operation of the processing system will be illustrated further with reference to Figure 10, Figure 11, Figure 12, Figure 13, Figure 14, Figure 15, Figure 16, and Figure 17.

Figure 10 shows measurements 141 comprising a thermal image acquired on a sidewall 31 of a tank 30 of an asset. The arrangement and attitude of the sensor (in this case a thermal camera) relative to the tank 30 causes distortions and may also cause some pixels representing background rather than the sidewall 31. The preprocessing performed by the processing system compensates, at least in part, such effects that are caused by the arrangement and attitude of the sensor, which may vary. To this end, the preprocessing may comprise cropping and/or coordinate transformation.

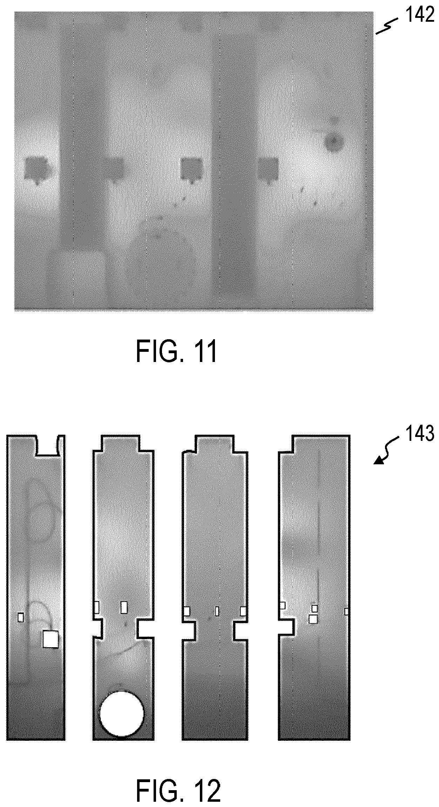

Figure 11 shows the cropped thermal image 142 with a coordinate transformation performed so as to map pixels of the thermal image to associated coordinates on the transformer wall.

As seen in Figure 11, there are pronounced temperature drops in certain areas, which are caused by structural components of the tank wall rather than the internal thermal dynamics of the asset. To reduce or eliminate the potential impact of such effects, the preprocessing may comprise a segmentation that removes or reduces such regions in which the thermal measurements are rendered unreliable by structural components of, e.g., the tank wall.

Figure 12 shows the pre-processed measurements 143, when the regions having artifacts (in the sense that the measurements are not indicative of the physical process embedded in the PIML model) caused by structural components are removed from the cropped thermal image 142.

The result of the preprocessing may be made available to a PIML model or other data-driven processing technique operative to predict both a parameter or several parameters (such as temperature and heat) and an uncertainty measure for the parameter or parameters in a spatially resolved manner.

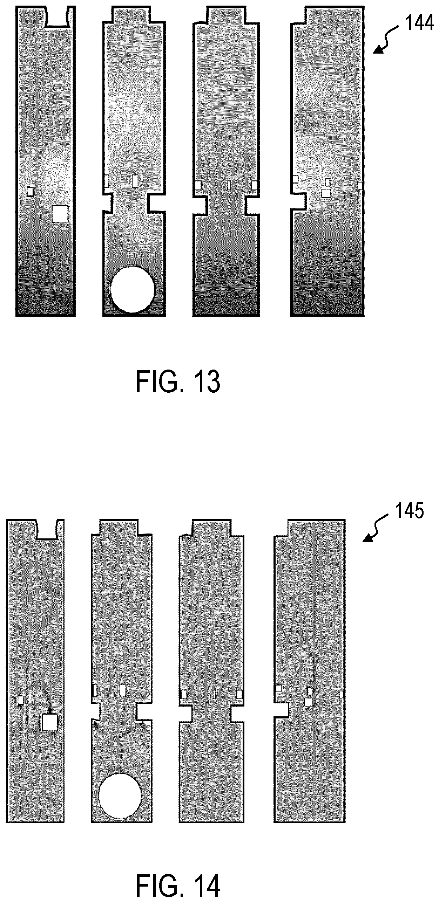

Figure 13 shows the predicted (mean) temperature 144 in a spatially resolved manner obtained using the PIML model. As will be appreciated that the mean temperature refers to the mean of a probability distribution for each location, rather than spatial averaging.

Figure 14 shows a difference 145 between the temperature 144 predicted using the PIML model and the measured temperature. In Figure 14, darker color represents a greater magnitude of the difference.

Figure 15 shows the predicted uncertainty measure 146 for the temperature in a spatially resolved manner, as obtained using the PIML model. In Figure 15, lighter colors represent a larger value of the uncertainty measure. As is evident by a comparison of Figure 14 and Figure 15, the PIML model correctly predicts regions 147 in which the uncertainty measure is larger (i.e., the confidence in the predicted temperature is smaller), that actually reflect the regions in which the difference between the temperature prediction and the actual prediction is large (Figure 14).

As is also evident from a comparison of Figure 14 and Figure 15, the PIML model correctly predicts regions 148 in which the uncertainty measure is small (i.e., the confidence in the predicted temperature is high). The uncertainty measure may, therefore, be used by the processing system 50 to determine one or several regions 148 from which the predicted temperature is obtained using the PIML model can be extrapolated or interpolated into regions 147 which the uncertainty measure is larger.

Figure 16 and Figure 17 illustrates the probabilistic PIML model that is used by the processing system. As used herein, the probabilistic PIML model is operative to predict both a mean or average value of a probability distribution for a parameter and an uncertainty measure indicative of a variance or other uncertainty metric for a probability distribution. The probabilistic PIML model may be operative to predict both a mean or average value of a Gaussian probability distribution for parameter and an uncertainty measure that is equal to or otherwise proportional to the variance of the Gaussian probability distribution. Figure 16 illustrates a probability distribution 151 for a parameter having an uncertainty measure 152. Figure 17 illustrates a further probability distribution 153 for the parameter having another uncertainty measure 154. The uncertainty measure, thus, quantifies how reliable the prediction of the mean values. It will be appreciated that the (mean) parameter and the confidence value are determined in a spatially resolved manner. I.e., not only the determined parameter but also the uncertainty measure will typically vary spatially and/or as a function of time, as shown in Figure 15.

The processing system 50 and the methods achieve an enhanced prediction accuracy. The PIML model operative to determine both an estimate of the (mean) of a parameter and an uncertainty measure therefor attains a better accuracy by being operative to ignore the irrelevant data and/or provide a smooth extrapolation to unreliable data where the ground truth is made unavailable and in difficult part of the geometry such as near the boundaries. From Figure 12, Figure 13, and Figure 14, it can be seen that the PIML model can mitigate the effect of irrelevant or unreliable (e.g., noisy) data in its prediction. As evidenced by Figure 15, the PIML model is operative to generate uncertainty measure(s) indicating that the PIML model is less confident in such regions and is more confident where the data is more reliable (e.g., in the interior).

The PIML model operative to determine both an estimate of the (mean) of a parameter and an uncertainty measure therefor quantifies the confidence in its prediction, which adds to the explainability. For example, the PIML model may be operative such that it indicates to be more confident in extrapolating its prediction to the regions where the ground truth is unreliable or unavailable, when such a region is juxtaposed to a region with reliable data and simpler geometry, as is depicted by region 148 in Figure 15. In contrast, the PIML model may be operative to indicate that it is less confident (shown by lighter colors in Figure 15) in its predictions in the regions extrapolated from the regions with difficult geometry or unreliable or irrelevant data, as is shown by regions 147 in Figure 15.

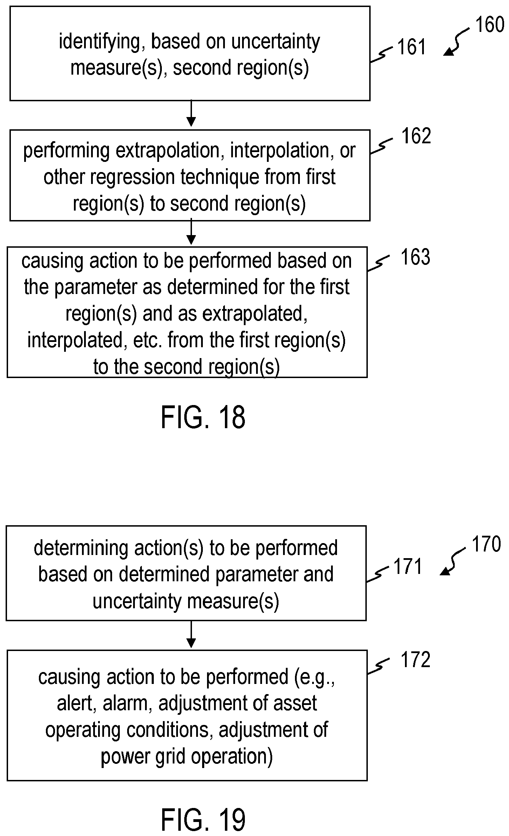

Figure 18 is a flow chart of a method 160. The method 160 may be performed automatically by the processing system 50.

At process block 161, the processing system 50 determines, based on the uncertainty measure or based on the uncertainty measures provided by the data-driven processing technique, first regions on the tank walls in which the determined at least one parameter value is considered to be reliable and at least one second region in which the uncertainty measure indicates that the determined at least one parameter value is not reliable. This identification may be performed using, for example, a threshold comparison. More complicated techniques may be used, such as filtering the uncertainty measure with a local filter kernel to remove of outliers that affect individual pixels only.

At process block 162, the processing system 50 performs an extrapolation or interpolation of the determined parameter value from one or several first regions (in which the parameter prediction is considered reliable) to the at least one second region (in which the parameter prediction is considered to be unreliable). Thus, the processing system 50 is operative to extrapolated or interpolated the determined parameter value, using the determined uncertainty measure.

At process block 163, the processing system 50 causes an action to be performed. The processing system 50 determines which action is to be performed based on both the parameter as predicted by the PIML model for the first region(s) and the interpolated or extrapolated parameter values obtained by interpolating or extrapolating the PIML model prediction from the first region(s) to the second region(s).

The action triggered at process block 163 may comprise an output action, in which the processing system 50 controls the HMI 52 or an HMI of the control system 49 to provide a warning, alert, or alarm, based on the results of the processing at process blocks 161 and 162. The action triggered at process 163 may alternatively or additionally comprise the generation of control data or control commands that effect an action acting on primary system equipment of the electric power system. The action triggered at process block 163 may alternatively or additionally comprise a change in measurement instrumentation, such as a change in position and/or orientation of a thermal camera, a change in a density or number of deployed sensors, or other corrective actions.

Figure 19 is a flow chart of a method 170. The method 170 may be performed automatically by the processing system 50 alone or in association with a control system 49 communicatively coupled to the processing system 50.

At process block 171, the processing system 50 determines which action is to be performed based on the at least one determined parameter and the at least one determined uncertainty measure. The action to be performed may be determined based on spatial and/or temporal variations of the determined at least one parameter and at least one uncertainty measure. Determining the action to be performed may comprise determining, based on a spatiotemporally varying temperature and/or heat distribution, whether there are unacceptable or potentially critical local losses in the asset. Determining the action to be for performed may further comprise determining, based on the at least one uncertainty measure for temperature and/or heat distribution, whether the temperature and/or heat predicted at a location corresponding to the identified local losses is associated with a sufficiently small uncertainty measure (e.g., with an uncertainty measure that is less than a threshold).

At process block 172, the processing system 50 causes the action determined at process block 171 to be performed. Causing the action to be performed may comprise any one or any combination of outputting a warning, alert, or an alarm. Causing the action to be performed may alternatively or additionally comprise causing, by the processing system 50 or by the control system 49 communicatively coupled thereto, an operation that affects the primary system of the electric power system that includes the asset 20.

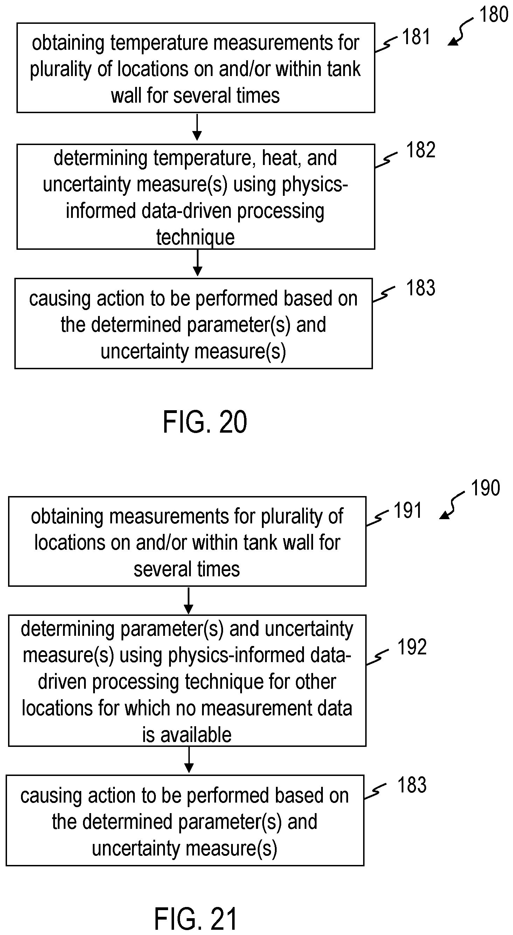

Figure 20 is a flow chart of a method 180. The method 180 may be performed automatically by the processing system 50.

At process block 181, the processing system obtains temperature measurements for a plurality of locations on a tank wall of the asset 20 and/or within the tank 30 of the asset 20. The processing system 50 may obtain the temperature measurements respectively for each one of several times. The processing system 50 may optionally also taking at least one operating condition, such as a load current and/or load power of the asset 20.

At process block 182, the processing system 50 determines temperature, optionally heat, and at least one uncertainty measure for temperature and/or heat using a physics informed data-driven processing technique, such as the PIML model 80. The temperature and/or heat and the at least one uncertainty measure for temperature and/or heat may be determined in a spatiotemporally resolved manner, i.e., for several locations on and/or within the tank wall and for several times. The locations for which temperature and/or heat and the uncertainty measure for temperature and/or heat are determined at process block 182 may be arranged more densely than the locations at which measurements are obtained at process block 181. Thereby, the PIML model 80 or other physics informed data-driven processing technique is operative to determine parameters such as temperature and/or heat and the at least one uncertainty measure for temperature and/or heat also for locations at which no measurements are available.

At process block 183, the processing system 50 may cause an action to be performed based on both the determined at least one parameter and at least one uncertainty measure. The action may be selected automatically by the processing system 50 based on a spatial variation, optionally a spatiotemporal variation, of the determined temperature and heat. Process block 183 may be implemented using any of the ways described in detail in association with process block 123.

Figure 21 is a flow chart of a method 190. The method 190 may be performed automatically by the processing system 50.

At process block 191, the processing system obtains temperature measurements for a plurality of locations on a tank wall of the asset 20 and/or within the tank 30 of the asset 20. The processing system 50 may obtain the temperature measurements respectively for each one of several times. The processing system 50 may optionally also obtain at least one operating condition, such as a load current and/or load power of the asset 20, as a function of time.

At process block 192, the processing system 50 determines temperature, optionally heat, and at least one uncertainty measure for temperature and/or heat using a physics informed data-driven processing technique, such as the PIML model 80. The determination at process block 192 is performed so as to determine the temperature and/or heat and associated uncertainty measure for locations at which no measurements are obtained at process block 191 and/or at which measurements are unreliable (e.g., due to the presence of structural components 36 of the tank 30). Thereby, the PIML model 80 or other physics informed data-driven processing technique is operative to determine parameters such as temperature and/or heat and the at least one uncertainty measure for temperature and/or heat also for locations at which no measurements are available and/or measurements are deemed unreliable. The temperature and/or heat and the at least one uncertainty measure for temperature and/or heat may be determined in a spatiotemporally resolved manner, i.e., for several locations on and/or within the tank wall and for several times.

At process block 193, the processing system 50 may cause an action to be performed based on both the determined at least one parameter and at least one uncertainty measure. The action may be selected automatically by the processing system 50 based on a spatial variation, optionally a spatiotemporally variation, of the determined temperature and heat. Process block 193 may be implemented using any of the ways described in detail in association with process block 123.

The processing system and method are not limited to processing measurements obtained using one or several of thermal cameras. For illustration, other thermal sensors may be provided to sense temperature at, e.g., a tank wall of the tank 30.

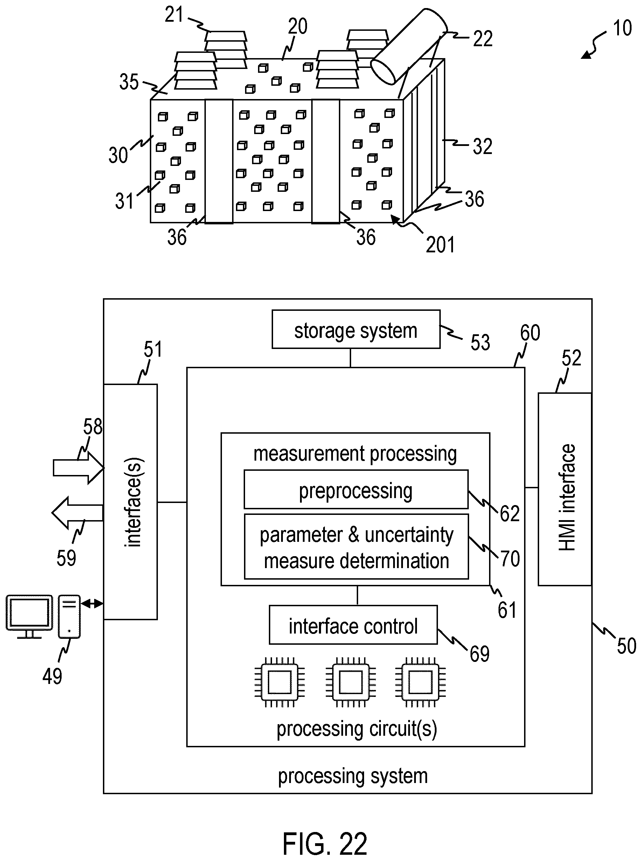

Figure 22 shows a schematic representation of a system 10 according to further embodiments. The system 10 comprises measurement instrumentation including a plurality of sensors 201 arranged and operative to sense temperature at a plurality of locations on one or several sidewalls 31, 32 and/or the cover 35 of the tank 30.

The processing system 50 is operative to process data 58 including the measurements captured by the plurality of sensors 201.

The at least one uncertainty measure determined by the processing system 50 may be used not only during field operation of the asset 20, but also during manufacture of the asset 20. For illustration, the at least one uncertainty measure determined in a spatially resolved manner, optionally in a spatiotemporally resolved manner, may be used to determine in which areas along the sidewalls 31, 32 and/or the cover 35 of the tank 30 additional sensors are to be arranged. Thereby, the sensor placement can be guided during the manufacture of the asset 20.

The processing system and method may be operative to process measurements captured using a thermal camera. The thermal camera may have a resolution of, e.g., at least $500\times500$ pixels, at least $800\times800$ pixels, or at least $1000\times1000$ pixels. Thermal images may be captured over a time period of several minutes, with at least 50, at least 100, or at least 150 images being captured and processed.

For illustration, the data shown in Figure 10, Figure 11, Figure 12, Figure 13, Figure 14, and Figure 15 were obtained using a thermal camera with more than $1000\times1000$ pixels, with more than one 150 images being captured over a period of several minutes and processed.

However, it has surprisingly been formed and demonstrated that the techniques, i.e. the processing system and method, remain operative even when much sparser data is used. To demonstrate this, performance of the PIML model 80 was checked for cases in which only a fraction of the pixels of the thermal camera were used for predicting spatiotemporal variations of temperature and/or heat and the associated uncertainty measure.

The trained PIML model 80 was tested using input that includes measurements for only 1/10 and 1/2000 of the pixels of the thermal camera. As the test set shown, the performance remains good even in cases of data sparsity in which only a fraction (1/10 and 1/2000 of the pixels) of the pixels of the thermal camera is used for generating the input of the PIML model 80.

To better understand PIML model's robustness on sparsity of data and the impact of data sparsity on the PIML model prediction accuracy and uncertainty, the data was undersampled to study its role on uncertainty quantification (UQ) of PIML model.

The variance in the PIML model's prediction, $\sigma_*^2(x)$ can be expressed as the sum of aleatoric and epistemic uncertainty, as is shown below.

$$\sigma_*^2(x) = \mathbb{E}_i[\sigma_i^2(x)] + Var_i[\mu_i(x)], \tag{1}$$

where the first term on the right-hand side of Eq. (1) is called aleatoric uncertainty and the second term on right-hand side of Eq. (1) is called epistemic uncertainty. Aleatoric uncertainty is related to data uncertainty that arises due to variability in the experiments and data collection processes (noise) and this uncertainty is reduced only by little or no amount by adding external information. Epistemic uncertainty, on the other hand, is the PIML model's uncertainty that arises due to lack of knowledge and thus can be reduced by adding information to the model training process.

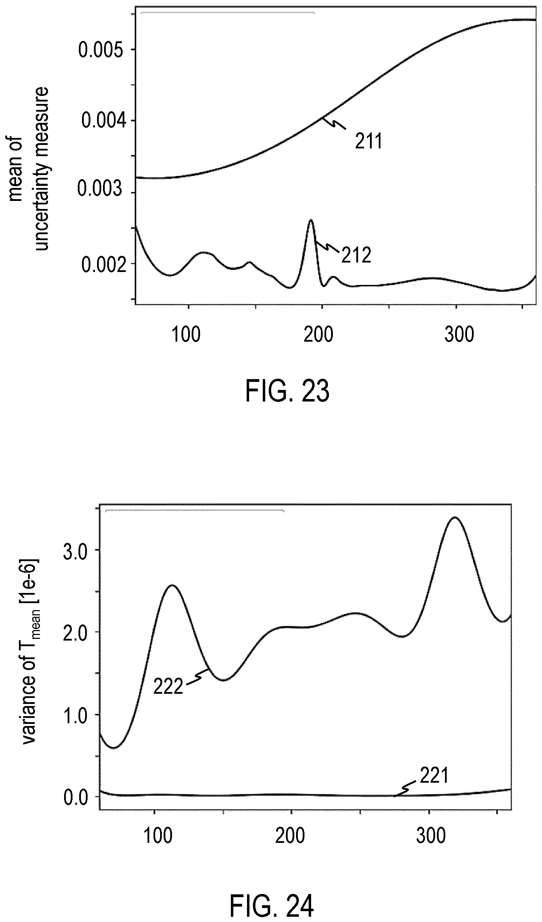

Figure 23 and Figure 24 show the effect of degree of under-sampling on aleatoric and epistemic uncertainty. It shows that a more aggressive undersampling (curves 212 and 222) of using 1/2000th of the original data points reduces average confidence (Figure 23) and slightly increases epistemic uncertainty (Figure 24) of the PIML model. The curves 211, 221 represent undersampling in which 1/10 of the original data points were used.

Thus, as shown in Figure 23, a higher degree of undersampling (curve 212) reduces the PIML model's confidence in its prediction (hence increasing aleatoric uncertainty). As shown in Figure 24, a higher degree of undersampling (curve 222) increases the variance of mean prediction (hence increasing epistemic uncertainty). Both in Figure 23 and in Figure 24, the abscissa refers to time samples.

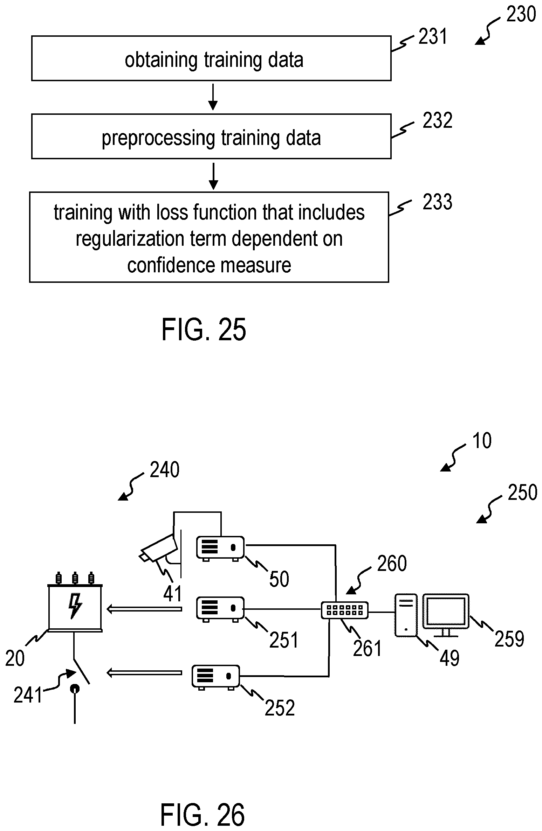

Figure 25 is a training method 230 of training the PIML model 80. The training method 230 may be performed by the processing system 50 or by a computing system different from the processing system 50.

At process block 231, training data is obtained. The training data may comprise measurements captured on the asset 20 or an asset having identical or similar construction as the asset 20 with which the PIML model 80 will be used during inference. The training data may comprise thermal measurements captured at a plurality of locations on at least two sidewalls 31, 32 of the tank 30. The training data may comprise such thermal measurements captured for a plurality of points in time, e.g. for at least 50, at least 100, or at least 150 sample times over a time period of several minutes. The training data may also comprise operating conditions, such as load current and/or load power, which may be obtained from measurement instrumentation or from settings of the control system 49.

At process block 232, the training data is preprocessed. Preprocessing the training data may comprise cropping and/or one or several coordinate transforms, identification of regions in which the measurements are deemed to be unreliable, removal of pixels or voxels in these regions in which the measurements are deemed to be unreliable, and/or interpolation or extrapolation, as previously explained.

At process block 233, the PIML model 80 is trained using a loss function. The loss function includes at least one regularization term that is dependent on the at least one uncertainty measure. The at least one regularization term may comprise a regularization term dependent on a logarithm of the uncertainty measure and/or a term that is inversely proportional to a power of the at least one uncertainty measure. By virtue of this regularization, the PIML model 80 is trained to provide solutions that have a low uncertainty measure, the river this is possible due to the structure of the asset 20. The loss function also includes a term dependent on the PDE residual of the PDE embedded in the PIML model 80. Thereby, the PIML model 80 is trained in such a manner that solutions that do not comply with the physical relationship reflected by the PDE are penalized.

Thus, as compared to C. Moya et al., "DeepONet-Grid-UQ: A Trustworthy Deep Operator Framework for Predicting the Power Grid's Post-Fault Trajectories", arXiv:2202.07176, not only the PIML model architecture but also the training loss is modified. The modified training loss $L_{total}$ comprises a probabilistic loss $L_{prob}$ and the PDE residual.

The probabilistic loss $L_{prob}$ used in the training includes a first term and a second term, with at least the second term providing a regularization that penalizes high uncertainty. The probabilistic loss $L_{prob}$ may be of the form

$$L_{prob} = L_{prob,1}\left(P_{pred} - P_{true}, \Omega\right) + L_{prob,2}(\Omega). \tag{2}$$

In Eq. (2), $P_{pred}$ - $P_{true}$ denotes a difference between the PIML model's prediction $P_{pred}$ of a parameter and the true value $P_{true}$ of the parameter, fl denotes the uncertainty measure for the parameter, $L_{prob,1}(P_{pred}$ - $P_{true}, \Omega)$ is a loss term that is monotonously increasing as a function of a modulus of $P_{pred}$ - $P_{true}$ and that is monotonously decreasing as a function of fl, and $L_{prob,2}(\Omega)$ denotes a regularization term that is monotonously increasing as a function of $\Omega$.

For illustration, for the data disclosed herein (e.g., with reference to Figure 10, Figure 11, Figure 12, Figure 13, Figure 14, Figure 15, Figure 23, and Figure 24), the function

$$L_{prob,1}\left(P_{pred} - P_{true}, \Omega\right) = \frac{\left(P_{pred} - P_{true}\right)^2}{\Omega^2} \tag{3}$$

was used during training.

For further illustration, for the data disclosed herein (e.g., with reference to Figure 10, Figure 11, Figure 12, Figure 13, Figure 14, Figure 15, Figure 23, and Figure 24), the function

$$L_{prob,2}(\Omega) = \log\left(2\pi\Omega^2\right) \tag{4}$$

was used during training. It will be appreciated that a wide variety of other functions that train the model to correctly predict the true parameter value while reducing the uncertainty measure may be used. For illustration, the regularization term dependent on the uncertainty measure may be of the form

$$L_{prob,2}(\Omega) = K \log(\Omega)  \tag{5}$$

with a constant K, without being limited thereto.

The first term in the expression for $L_{prob}$, $L_{prob,1}(P_{pred} - P_{true}, \Omega)$, quantifies the degree to which the model's prediction approximates the ground truth. When the model is very confident in its prediction, $\Omega$ is low, and causing $L_{prob,1}$ $(P_{pred} - P_{true}, \Omega)$ to increase and preventing the model to fit too tightly to the data. At the same time, the when the model is not very confident, $\Omega$ is high and hence the second term in the expression of $L_{prob}$, $L_{prob,2}(\Omega)$, is high, thus encouraging the model to focus on lowering the variance $|P_{pred} - P_{true}$ and reducing the uncertainty measure fl. Thus, the presence of the uncertainty measure ($\Omega$) acts as a regularizer to help model not to overfit to the data, thus reducing the chance of fitting to unreliable or irrelevant data, as is shown in Figure 12, Figure 13, and Figure 14.

The total loss function may include the probabilistic loss function $L_{prob}$ and a term that is dependent on the PDE residual. For illustration,

$$L = L_{prob} + F(\varepsilon)  \tag{6}$$

where L is the total loss function, $L_{prob}$ is the probabilistic loss function, and $F(\varepsilon)$ is a function dependent on the PDE residual which may be monotonously increasing as a function of modulus of the PDE differential. For illustration, $F(\varepsilon) = |\varepsilon|$ or $F(\varepsilon) = \varepsilon^2$ may be used.

When the uncertainty measure is determined for more than one parameter, the probabilistic loss may have the form

$$L_{prob} = \sum_i \left( L_{prob,1}(P_{i,pred} - P_{i,true}, \Omega_i) + L_{prob,2}(\Omega_i) \right)$$

$$\tag{7}$$

where the index $i$ labels the parameter for any parameter for which measurements or observations are available, $P_{i,pred}$ is the PIML model's prediction for the $i^{th}$ parameter value, $P_{i,true}$ is the ground truth for the $i^{th}$ parameter value, and $\Omega_i$ is the uncertainty measure for the $i^{th}$ parameter value.

As was explained with reference to Figure 10 and Figure 11, the structure of the tank 30 and/or the structure of the asset components within the tank 30 may have the effect that some measurements of the data is less reliable than other. This also applies to the training. For illustration, portions of thermal images may have data that is unreliable (in the sense that it is not appropriate for insertion into the thermal diffusion equation) in areas in which structural components such as reinforcements or struts 36 provide heat sinks and/or thermal shielding. It is often possible to identify such regions from the measurements used for the training, e.g., as regions in the thermal camera image having a boundary at which the temperature appears to exhibit a discontinuity. To improve the PIML model training and robustness of the predictions provided by the PIML model, the training may include any one or any combination of:

- Training the PIML model without the unreliable data.
- Training the PIML model with reliable temperature data and learning to interpolate into the unreliable regions by using the knowledge of underlying PDE, which weakly enforces consistency between temperature and heat source estimates.
- Compensating for limited amount of reliable measurement data (e.g., using multiple types of measurement device, generative modeling to create realistic and physically sound synthetic data from local simulations.)

For the data disclosed herein (e.g., with reference to Figure 10, Figure 11, Figure 12, Figure 13, Figure 14, Figure 15, Figure 23, and Figure 24), the training data was captured using a thermal camera with a chip of more than 1000 x 1000 pixels, with a series of 200 images being captured over a time period of several minutes in which the load current was varied. The training data were captured on a power transformer having a tank filled with insulation oil.

However, as already explained with reference to Figure 23 and Figure 24, the techniques disclosed herein remain operative even when undersampling the available thermal image data. Thus, the PIML model may also be trained with a smaller number of sample times and/or a smaller number of measurement locations at each sample time.

As already explained, the processing system 50 may be operative to trigger an action based on the determined at least one parameter and the determined at least one uncertainty measure. The processing system 50 may be integrated into or communicatively coupled with an automation control system of an electric power system. Exemplary configurations are explained with reference to Figure 26, Figure 27, Figure 28, and Figure 29.

Figure 26, Figure 27, Figure 28, and Figure 29 respectively show a system 10 comprising an electric power system. The electric power system comprises a primary system equipment that may comprise the asset 20. The primary system equipment may further comprise components suitable for protection of the asset 20, such as a circuit breaker or switchgear 241. The electric power system may further comprise an automation control system 250. The automation control system 250 may comprise a plurality of intelligent electronic devices (IEDs). The automation control system 250 may comprise a communication system 260 that allows the intelligent electronic devices to communicate with each other and/or with a control system 49. An HMI 259 may be coupled to or comprised by the control system 49. The communication system 260 may comprise communication infrastructure, such as a communication switched 261, to enable communication between the IEDs. As previously explained, the system 10 comprises measurement instrumentation 41 operative to capture measurement data of the asset 20, such as thermal images or other thermal measurements. The system 10 further comprises a processing system 50 operative to process the measurements to determine one or several parameters and one or several uncertainty measures for the one or several parameters in a manner that is at least spatially resolved, in the sense that the one or several parameters and one or several uncertainty measures are determined for a plurality of locations on a tank of the asset 20.

Figure 26 shows a system 10 comprising a first IED 251 operative to perform control and/or monitoring functions for the asset 20. The asset 20 may be a power transformer or shunt reactor, without being limited thereto. The system 10 comprises a second IED 252 operative to cause the switchgear 241 to trip. The system 10 may be operative such that the processing system 50 generates output that causes at least one of the IEDs 251, 252 to perform an operation responsive on the output of the processing system 50, with the output of the processing system 50 being dependent on both the determined at least one parameter and the determined uncertainty measure for the at least one parameter. Alternatively or additionally, the system 10 may be operative such that the processing system 50 generates output that causes a warning, alert, alarm, or other status information relating to the asset 20 to be provided via the HMI 259, with the warning, alert, alarm, or other status information being dependent on both the determined at least one parameter and the determined uncertainty measure for the at least one parameter.

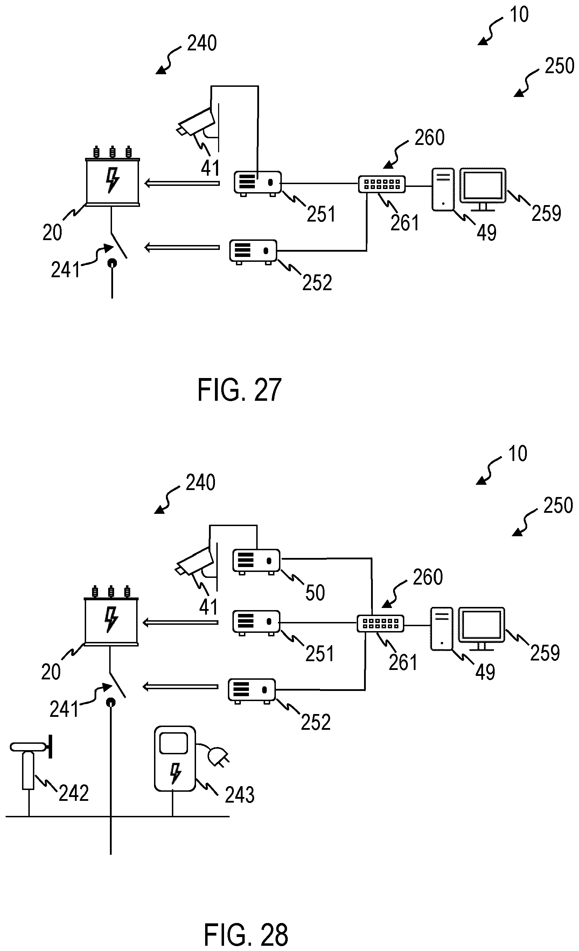

Figure 27 shows a modification of the system of Figure 26. In Figure 27, at least one IED 251 of the system 10 comprises the processing system 50 operative as disclosed herein.

The techniques disclosed herein are particularly applicable to electric power systems that comprise distributed energy resources or other renewable energy sources and/or a time coupling equipment such as vehicles charging equipment.

Figure 28 shows a system 10 comprising the processing system 50, wherein the electric power system comprises primary system equipment 240 that includes both the asset 20 and at least one of a renewable energy source 242 and electric vehicle charging equipment 243.

The techniques disclosed herein are also particularly applicable to electric power systems that comprise a high voltage direct current (HVDC) system.

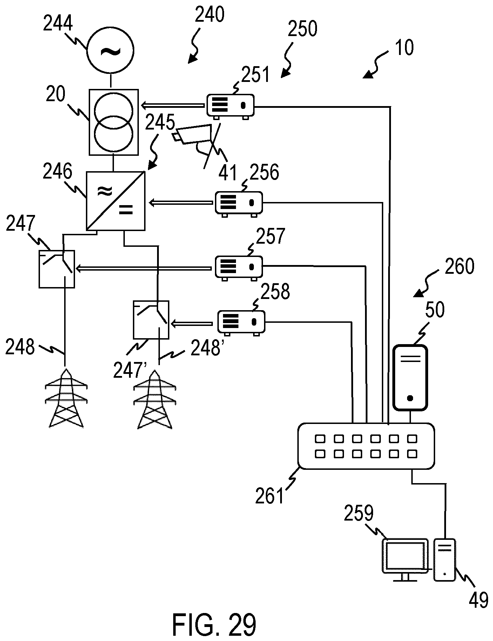

Figure 29 shows a system 10 comprising the processing system 50. The primary system equipment 240 comprises a power transformer 20 coupled to an AC system 244 and an inverter/converter 246. The primary system equipment 240 comprises the HVDC system 245. The HVDC system 245 comprises DC transmission lines or cables that may be implemented in a redundant manner by DC transmission lines or cables 248, 248'. The HVDC system 245 comprises protection equipment such as disconnectors 247, 247' for the lines or cables 248, 248'.

The system 10 comprises measurement instrumentation 41. The processing system 50 may be operative to generate output that causes at least one IED of the automation control system 250 to operate based on the output of the processing system 50. The output of the processing system 50 is dependent on both the predicted parameter value and the predicted uncertainty measure. The system 10 may be operative such that at least one of an IED 251 associated with a power transformer 20, an IED 256 associated with the converter/inverter 246, an IED 257, 258 associated with a disconnector 247, 247' is operated based on the output of the processing system 50 in a manner which affects the primary system equipment 240.

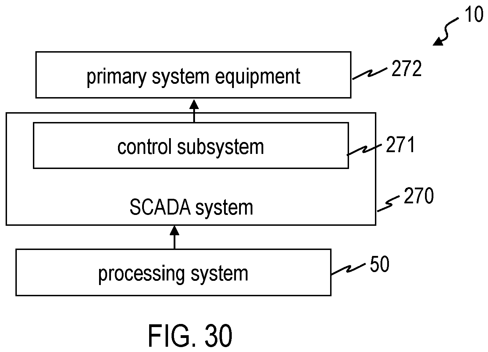

Figure 30 shows a schematic representation of a system 10 that comprises the processing system 50. The system 10 further comprises a SCADA system 270 comprising a control subsystem 271. The control subsystem 271 is operative to control primary system equipment 272 based on output generated by the processing system 50. The control subsystem 271 may be operative to change operation of the asset 20, for which the processing system 50 determines at least one parameter and at least one uncertainty measure, or of other primary system equipment that is related to operation of the asset 20. For illustration, identification of a local loss in the asset 20 by the processing system 50 may cause the control subsystem 271 to change a load current and/or load power of the asset, to change a tap changer position, or to perform yet another control action suitable to mitigate the potentially critical situations.

Various effects and advantages are attained by the processing system, method, and system according to embodiments. The processing system and method provide enhanced techniques of determining a parameter and an associated uncertainty measure in a spatially resolved manner for an asset, using a data-driven processing technique that may have embedded therein physics knowledge.

The processing system and method allow temperature and/or heat to be determined using a PIML model, enabling the temperature and/or heat to be determined also for regions on a tank sidewall and/or tank cover at which measurements are unreliable or not available. By providing the uncertainty measure (such as by determining a logarithm of a variance of a probability distribution), information quantifying the PIML model's confidence in its prediction is available and is used for generating output.

While embodiments have been described in detail with reference to the drawings, various modifications may be implemented in other embodiments. For illustration rather than limitation:

- While embodiments have been described in association with an asset that comprises a power transformer or shunt reactor having a tank, the techniques may also be used in association with other equipment, such as measurement transformers.
- While embodiments have been described in which the processing system 50 is comprised by or communicatively interfaced with a SCADA system, the processing system 50 can also be used in other use cases, e.g., to perform offline asset analysis.
- While embodiments have been described in which the PIML model has embedded therein a thermal diffusion equation and is trained to predict temperature and/or heat and an uncertainty measure for temperature and/or heat in a spatially resolved manner, the techniques disclosed herein are not limited to this use case. For illustration, the techniques disclosed herein may be used in association with PDEs other than thermal diffusion, in particular in association with other physical parameters of an asset that have to fulfill a PDE that links a first order partial time derivative and a second order spatial derivative (such as a 2D or 3D Laplace operator) to each other and/or to another parameter.
- While preprocessing may be performed as described herein, preprocessing may alternatively or additionally be performed using any one of the techniques disclosed in applicant's application entitled "METHOD AND PROCESSING SYSTEM FOR USE WITH AN ASSET OF AN ELECTRIC POWER SYSTEM, AND METHOD OF PROVIDING A PHYSICS INFORMED MACHINE LEARNING MODEL" filed on the same day as the present application.

Embodiments may be used in association with a power grid having renewables penetration, such as power grid comprising renewable energy systems (such as DERs), and/or in association with a power grid having a HVDC system, without being limited thereto.

This description and the accompanying drawings that illustrate aspects and embodiments of the present invention should not be taken as limiting-the claims defining the protected invention. In other words, while the invention has been illustrated and described in detail in the drawings and foregoing description, such illustration and description are to be considered illustrative and not restrictive. Various mechanical, compositional, structural, electrical, and operational changes may be made without departing from the spirit and scope of this description and the claims. In some instances, well-known circuits, structures and techniques have not been shown in detail in order not to obscure the invention. Thus, it will be understood that changes and modifications may be made by those of ordinary skill within the scope and spirit of the following claims. In particular, the present invention covers further embodiments with any combination of features from different embodiments described above and below.

The disclosure also covers all further features shown in the Figures individually although they may not have been described in the afore or following description. Also, single alternatives of the embodiments described in the Figures and the description and single alternatives of features thereof can be disclaimed from the subject matter of the invention or from disclosed subject matter. The disclosure comprises subject matter consisting of the features defined in the claims or the embodiments as well as subject matter comprising said features.

The term "comprising" does not exclude other elements or process blocks, and the indefinite article "a" or "an" does not exclude a plurality. A single unit or process block may fulfil the functions of several features recited in the claims. The mere fact that certain measures are recited in mutually different dependent claims does not indicate that a combination of these measures cannot be used to advantage. Components described as coupled or connected may be electrically or mechanically directly coupled, or they may be indirectly coupled via one or more intermediate components. Any reference signs in the claims should not be construed as limiting the scope.

A machine-readable instruction code may be stored/distributed on a suitable medium, such as an optical storage medium or a solid-state medium supplied together with or as part of other hardware, but may also be distributed in other forms, such as via a wide area network or other wired or wireless telecommunication systems. Furthermore, a machine-readable instruction code can also be a data structure product or a signal for embodying a specific method such as the method according to embodiments.

**Claims**

1. A method for use in association with an asset (20) of an electric power system (10), the method comprising:

receiving, at at least one interface (51) of a processing system (50), data (58) comprising measurements for several different measurement locations at or in proximity to the asset (20);

performing, by at least one processing circuit (60) of the processing system (50), a determination of at least one parameter of the asset (20), comprising applying a data-driven processing technique to input data (64) that are based on the measurements to determine

the at least one parameter (144) and
at least one uncertainty measure (146) for one or several parameters of the at least one parameter; and

generating, by the processing system (50), output (59) based on the determination.

2. The method of claim 1, wherein the data-driven processing technique comprises a physics informed machine learning, PIML, model (80).

3. The method of claim 2, wherein the PIML model (80) has a PIML output (87, 93, 96; 93, 96; 87, 93, 96, 106) operative to provide the at least one parameter and the at least one uncertainty measure.

4. The method of claim 2 or claim 3, wherein the PIML model comprises

a first plurality of neural network, NN, layers (97) having a first input layer (92),
a second plurality of NN layers (99) operative to process a first output of the first plurality of NN layers (97) and having a second output (93) to provide the at least one parameter, and
a third plurality of NN layers (98) operative to process the first output of the first plurality of NN layers (97) and having a third output (96) to provide the at least one uncertainty measure.

5. The method of any one of claims 2 to 4, wherein the PIML model (80) is operative to provide a first parameter and a second parameter, wherein the PIML model (80) embeds a partial differential equation, PDE, that is dependent on the first parameter and the second parameter, optionally wherein the PDE comprises a thermal diffusion equation.

6. The method of any one of the preceding claims, wherein

the asset (20) comprises a tank (30) having a tank wall (31, 32, 35),
the data comprise thermal measurement data obtained at and/or within the tank wall (31, 32, 35),
the at least one parameter comprises a temperature (144) and/or heat, and
the at least one uncertainty measure comprises a temperature uncertainty measure (146) of temperature and/or a heat uncertainty measure for regions of the tank that have one, several, or all of:

absence of measurement locations;
reduced reliability of the measurements;
lower density of measurement locations than other spatial zones.

7. The method of any one of the preceding claims, wherein performing the determination comprises preprocessing (62), by the at least one processing circuit (60), the measurements to generate the input data (64), wherein preprocessing the measurements comprises one, several, or all of:

applying a coordinate transform to transform coordinates of pixel or voxel values comprised by the measurements (141) to a coordinate system of the asset (20);
performing a segmentations of at least one array of pixel or voxel values (142, 143) comprised by the measurements to identify zones in which the measurements are unreliable;
determining pixel or voxel values for zones in which structural components (36) of the asset (20) reduce the reliability of the measurements, comprising an interpolation, extrapolation, or regression technique.

8. The method of any one of the preceding claims, wherein the measurements comprise spatially resolved thermal measurements, optionally wherein the spatially resolved thermal measurements are received from one, several, or all of: at least one thermal camera (41, 42), at least one thermocouple, at least one fiber optic sensor operative to sense temperature.

9. The method of any one of the preceding claims, wherein the data-driven processing technique is operative to model thermal dynamics in the asset (20), taking into account thermal diffusion, in a spatially resolved manner along at least two spatial directions.

10. The method of any one of the preceding claims, wherein the output (59) comprises one or both of:

output for an operator interface (52, 259) of the electric power system (10), optionally wherein the method comprises controlling the operator interface (52, 259) to provide the output;
output (59) that triggers at least one control action within the electric power system (10).

11. The method of any one of the preceding claims, wherein the asset (20) comprises a transformer (20) and/or a shunt reactor, wherein the input data (64) are generated based on measurements obtained at a tank wall (31, 32, 35) of the asset (20).

12. A method of controlling an electric power system (10), comprising:

performing, by a processing system (50), the method of any one of the preceding claims to predict local losses in the asset (20) of the electric power system (10), and
performing, by the processing system (50) or a control system (49) operatively coupled with the processing system (50), at least one control operation based on the output (59).

13. A training method of training a physics informed machine learning, PIML, model (80) for use in the method of any one of the preceding claims, the training method comprising:

obtaining training data comprising measurements captured on a tank wall (31, 32, 35) of the asset (20),
training the PIML model (80), wherein a loss function for the training comprises a regularization term that is dependent on the at least one uncertainty measure, and
providing PIML model data obtained in the training for use in the method of any one of the preceding claims.

14. A processing system (50), comprising:

at least one interface (51) operative to receive data (58) comprising measurements (141) for several different measurement locations at or in proximity to an asset (20) of an electric power system (10); and
at least one processing circuit (60) operative to perform a determination of at least one parameter of the asset (20), comprising applying a data-driven processing technique to input data that are based on the measurements (141) to determine

the at least one parameter (144) and
at least one uncertainty measure (146) for one or several parameters of the at least one parameter,

the processing system (50) being operative to generate output (59) based on the determination.

15. An electric power system (10), comprising:

an asset (20);
measurement instrumentation (41, 42; 201) operative to perform measurements for several different measurement locations at or in proximity to the asset (20); and
the processing system (50) of claim 14 operative to process data (58) acquired using the measurements.

FIG. 1

measurement processing

63

preprocessing

62

64

parameter & uncertainty measure determination

processing using a physics informed data-driven processing technique

71

70

67        66

61

FIG. 2

FIG. 3

FIG. 4

FIG. 5

FIG. 6

preprocessing measurements ⌇ 121    ⌇ 120

↓

determining parameter(s) and uncertainty measure(s) using physics-informed data-driven processing technique ⌇ 122

↓

causing action to be performed based on the determined parameter(s) and uncertainty measure(s) ⌇ 123

## FIG. 7

63

measurement processing

preprocessing

cropping and/or
coordinate transformation                   62a

segmentation                                62b

interpolation and/or
extrapolation and/or filter                 62c
operations

62

64

parameter & uncertainty measure
determination

processing using a
physics informed data-                      71
driven processing
technique

70

67                              66

61

FIG. 8

130

| obtaining spatio-temporal thermal data for tank wall | obtaining operating condition(s) affecting heat generation |
|---|---|

131          132

processing the thermal data and operating condition(s) to determine temperatures and heat generation and uncertainty measure(s)

133

causing action to be performed based on the determined parameter(s) and uncertainty measure(s)

123

FIG. 9

141

FIG. 10

FIG. 11

FIG. 12

FIG. 13

FIG. 14

FIG. 15

FIG. 16

FIG. 17

identifying, based on uncertainty measure(s), second region(s) — 161  160

performing extrapolation, interpolation, or other regression technique from first region(s) to second region(s) — 162

causing action to be performed based on the parameter as determined for the first region(s) and as extrapolated, interpolated, etc. from the first region(s) to the second region(s) — 163

## FIG. 18

determining action(s) to be performed based on determined parameter and uncertainty measure(s) — 171  170

causing action to be performed (e.g., alert, alarm, adjustment of asset operating conditions, adjustment of power grid operation) — 172

## FIG. 19

181

obtaining temperature measurements for plurality of locations on and/or within tank wall for several times

180

182

determining temperature, heat, and uncertainty measure(s) using physics-informed data-driven processing technique

183

causing action to be performed based on the determined parameter(s) and uncertainty measure(s)

FIG. 20

191

obtaining measurements for plurality of locations on and/or within tank wall for several times

190

192

determining parameter(s) and uncertainty measure(s) using physics-informed data-driven processing technique for other locations for which no measurement data is available

183

causing action to be performed based on the determined parameter(s) and uncertainty measure(s)

FIG. 21

FIG. 22

FIG. 23

FIG. 24

230

231

obtaining training data

232

preprocessing training data

233

training with loss function that includes regularization term dependent on confidence measure

FIG. 25

10

240

250

260

50

41

251

261

20

241

252

259

49

FIG. 26

FIG. 27

FIG. 28

FIG. 29

10

| primary system equipment | 272 |

| control subsystem | 271 |

SCADA system — 270

| processing system | 50 |

FIG. 30

Europäisches
Patentamt
European
Patent Office
Office européen
des brevets

# EUROPEAN SEARCH REPORT

**Application Number**

EP 23 20 9949

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 953 444 A (ELECTRIC POWER SCIENCE RES INST OF STATE GRID ANHUI ELECTRIC POWER CO) 27 October 2023 (2023-10-27) | 1-3,14, 15 | INV. G01R31/62 G01R31/72 |
| A | * page 2, paragraph 3 * | 6,8,9 | |
| A | XU YANWEN ET AL: "Physics-informed machine learning for reliability and systems safety applications: State of the art and challenges", RELIABILITY ENGINEERING AND SYSTEM SAFETY., vol. 230, 1 February 2023 (2023-02-01), page 108900, XP093065254, GB ISSN: 0951-8320, DOI: 10.1016/j.ress.2022.108900 * Section 2.2.1, 2.2.2; figure 1 * | 4,5 | |
| X | US 2023/082184 A1 (WANG HONGGANG [US] ET AL) 16 March 2023 (2023-03-16) | 12,13 | |
| A | * paragraphs [0026], [0032], [0042], [0067] – [0074] * | 10,11 | TECHNICAL FIELDS SEARCHED (IPC) G01R H02J G01K |
| A | MEHDI JABBARI ZIDEH ET AL: "Physics-Informed Machine Learning for Data Anomaly Detection, Classification, Localization, and Mitigation: A Review, Challenges, and Path Forward", ARXIV.ORG, CORNELL UNIVERSITY LIBRARY, 201 OLIN LIBRARY CORNELL UNIVERSITY ITHACA, NY 14853, 19 September 2023 (2023-09-19), XP091618373, * the whole document * | 1-15 | |

-/--

The present search report has been drawn up for all claims

| Place of search | Date of completion of the search | Examiner |
|---|---|---|
| Munich | 29 April 2024 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 3

Europäisches
Patentamt
European
Patent Office
Office européen
des brevets

# EUROPEAN SEARCH REPORT

**Application Number**

EP 23 20 9949

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HUBER LILACH GOREN ET AL: "Physics-Informed Machine Learning for Predictive Maintenance: Applied Use-Cases", 2023 10TH IEEE SWISS CONFERENCE ON DATA SCIENCE (SDS), IEEE, 22 June 2023 (2023-06-22), pages 66-72, XP034390364, DOI: 10.1109/SDS57534.2023.00016 [retrieved on 2023-08-02] * the whole document * | 1-15 | |
| A | ALFONSO GIJ\'ON ET AL: "Prediction of wind turbines power with physics-informed neural networks and evidential uncertainty quantification", ARXIV.ORG, CORNELL UNIVERSITY LIBRARY, 201 OLIN LIBRARY CORNELL UNIVERSITY ITHACA, NY 14853, 27 July 2023 (2023-07-27), XP091575695, * the whole document * | 1-15 | |
| A | KARNIADAKIS GEORGE EM ET AL: "Physics-informed machine learning", NATURE REVIEWS PHYSICS, [Online] vol. 3, no. 6, 24 May 2021 (2021-05-24), pages 422-440, XP093005789, DOI: 10.1038/s42254-021-00314-5 [retrieved on 2024-04-20] * the whole document * | 1-15 | |

TECHNICAL FIELDS
SEARCHED        (IPC)

-/--

The present search report has been drawn up for all claims

| Place of search | Date of completion of the search | Examiner |
|---|---|---|
| Munich | 29 April 2024 | Dogueri, Ali Kerem |

EPO FORM 1503 03.82 (P04C01)

Europäisches
Patentamt

European
Patent Office

Office européen
des brevets

# EUROPEAN SEARCH REPORT

**Application Number**

EP 23 20 9949

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GJORGIEV BLAZHE ET AL: "Simulation-driven deep learning for locating faulty insulators in a power line", RELIABILITY ENGINEERING AND SYSTEM SAFETY, ELSEVIER APPLIED SCIENCE, GB, vol. 231, 23 November 2022 (2022-11-23), XP087235087, ISSN: 0951-8320, DOI: 10.1016/J.RESS.2022.108989 [retrieved on 2022-11-23] * the whole document * | 1-15 | |
| A | US 2023/258733 A1 (GERING KEVIN L [US] ET AL) 17 August 2023 (2023-08-17) * the whole document * | 1-15 | |
| A,D | US 2020/293594 A1 (RAISSI MAZIAR [US] ET AL) 17 September 2020 (2020-09-17) * the whole document * | 1-15 | |
| A,D | BRAGONE FEDERICA ET AL: "Physics-informed neural networks for modelling power transformer's dynamic thermal behaviour", ELECTRIC POWER SYSTEMS RESEARCH, ELSEVIER, AMSTERDAM, NL, vol. 211, 13 July 2022 (2022-07-13), XP087135125, ISSN: 0378-7796, DOI: 10.1016/J.EPSR.2022.108447 [retrieved on 2022-07-13] * the whole document * | 1-15 | **TECHNICAL FIELDS SEARCHED** (IPC) |

The present search report has been drawn up for all claims

| Place of search | Date of completion of the search | Examiner |
|---|---|---|
| Munich | 29 April 2024 | Dogueri, Ali Kerem |

EPO FORM 1503 03.82 (P04C01)

page 3 of 3

## ANNEX TO THE EUROPEAN SEARCH REPORT
## ON EUROPEAN PATENT APPLICATION NO.

**EP 23 20 9949**

This annex lists the patent family members relating to the patent documents cited in the above-mentioned European search report.
The members are as contained in the European Patent Office EDP file on
The European Patent Office is in no way liable for these particulars which are merely given for the purpose of information.

**29-04-2024**

| Patent document cited in search report | | Publication date | Patent family member(s) | | Publication date |
|---|---|---|---|---|---|
| CN 116953444 | A | 27-10-2023 | NONE | | |
| US 2023082184 | A1 | 16-03-2023 | NONE | | |
| US 2023258733 | A1 | 17-08-2023 | NONE | | |
| US 2020293594 | A1 | 17-09-2020 | US 2020293594 A1 | | 17-09-2020 |
| | | | WO 2018013247 A2 | | 18-01-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20200293594 A1

### Non-patent literature cited in the description

- Physics-informed neural networks for modelling power transformer's dynamic thermal behaviour. **F. BRAGONE et al.** Electric Power Systems Research. Elsevier, October 2022, vol. 211, 108447

- **C. MOYA et al.** DeepONet-Grid-UQ: A Trustworthy Deep Operator Framework for Predicting the Power Grid's Post-Fault Trajectories. *arXiv:2202.07176*